# FASCICULE DE BREVET EUROPEEN

(11) **EP 2 304 794 B1**
(45) Date de publication et mention de la délivrance du brevet: **20.09.2017**
(21) Numéro de dépôt: 09793968.0
(22) Date de dépôt: 10.07.2009
(51) Int. Cl.: H01L 27/115, H01L 27/11568, H01L 27/11578, H01L 27/11582, H01L 21/822, H01L 21/8246, H01L 27/06, H01L 27/12

(54) **STRUCTURE ET PROCEDE DE REALISATION D'UN DISPOSITIF MICROELECTRONIQUE DE MEMOIRE 3D DE TYPE FLASH NAND**
STRUKTUR UND VERFAHREN ZUR HERSTELLUNG EINER MIKROELEKTRONISCHEN 3D-NAND-FLASH-SPEICHERVORRICHTUNG
STRUCTURE AND PROCESS FOR FABRICATING A MICROELECTRONIC 3D NAND FLASH MEMORY DEVICE

(30) Priorité: 10.07.2008 FR 0854729
(43) Date de publication de la demande: 06.04.2011
(73) Titulaire: Commissariat à l'Énergie Atomique et aux Énergies Alternatives, 75015 Paris (FR)
(72) Inventeur: ERNST, Thomas, 38210 Morette (FR); MOLAS, Gabriel, 38000 Grenoble (FR); DE SALVO, Barbara, 38330 Montbonnot Saint Martin (FR); BECU, Stéphanel, 38190 La Combe de Lancey (FR)
(74) Mandataire: Ilgart, Jean-Christophe
(86) Numéro de dépôt international: PCT/EP2009/058870
(87) Numéro de publication internationale: WO 2010/004047

(56) Documents cités:
- US-A1- 2007 252 201
- US-A1- 2008 073 635
- US-A1- 2008 099 819
- US-A1- 2008 149 913
- FUKUZUMI Y, TANAKA H ET AL: "Optimal integration and characteristics of vertical array devices for ultra-high density, bit-cost scalable flash memory" IEDM 2007 TECH. DIG., 2007, pages 449-452, XP008101292 cité dans la demande
- TANAKA H ET AL: "Bit Cost Scalable Technology with Punch and Plug Process for Ultra High Density Flash Memory" VLSI TECHNOLOGY, 2007 IEEE SYMPOSIUM ON, IEEE, PI, 1 juin 2007 (2007-06-01), pages 14-15, XP031139616 ISBN: 978-4-900784-03-1 cité dans la demande
- SOON-MOON JUNG ET AL: "Three Dimensionally Stacked NAND Flash Memory Technology Using Stacking Single Crystal Si Layers on ILD and TANOS Structure for Beyond 30nm Node" ELECTRON DEVICES MEETING, 2006. IEDM '06. INTERNATIONAL, IEEE, PI, 1 décembre 2006 (2006-12-01), pages 1-4, XP031078315 ISBN: 978-1-4244-0438-4 cité dans la demande

## Description

### DOMAINE TECHNIQUE

La présente invention se rapporte au domaine de la microélectronique, et plus particulièrement à celui des mémoires, et a pour but de présenter une mémoire 3D réinscriptible, en particulier une mémoire non-volatile de type Flash, telle qu'une mémoire NAND, comportant des points mémoires ou cellules réparti (e) s sur 3 dimensions, formée à l'aide d'au moins une structure comportant plusieurs grilles formées autour de barreaux à base de matériau semi-conducteur parallèles reliant des blocs semi-conducteurs, les grilles reposant sur une superposition de couches comportant au moins une zone de stockage de charges.

La présente invention concerne également un procédé de fabrication d'une telle mémoire.

### ART ANTÉRIEUR

On cherche continuellement à augmenter la densité des mémoires. Pour cela, on essaie de réaliser des cellules de taille de plus en plus réduite. Pour des technologies de mémoires dans lesquelles les longueurs de grille sont inférieures à 30 nm, les performances des mémoires sont limitées du fait d'une isolation insuffisante des points mémoires entre eux, et des effets de canaux courts.

Par ailleurs, les procédés de lithographie pour des dimensions critiques en dessous de 30 nanomètres présentent des difficultés de mise en oeuvre. Ces dernières pouvant augmenter le coût de fabrication de manière significative.

Pour améliorer la densité d'intégration, des mémoires 3D dans lesquelles les points mémoires sont répartis sur 3 dimensions, sont apparues. De telles mémoires peuvent être réalisées par exemple par empilement de plusieurs puces. L'avantage en terme de gain en coût, de la mise en oeuvre d'un tel dispositif est faible ou nul, dans la mesure où la réalisation de telles mémoires n'implique pas de réduction du nombre d'étapes technologiques.

Il est également possible de réaliser plusieurs niveaux mémoires empilés sur un même substrat. Dans ce cas, on reporte sur un niveau mémoire déjà réalisé une couche semi-conductrice supplémentaire qui peut être à base de polysilicium, ou de silicium amorphe recristallisé par recuit thermique. Un autre niveau mémoire est alors réalisé sur cette couche semi-conductrice supplémentaire.

Le document de S.-M. Jung et al.: "Three Dimensionally Stacked NAND Flash Memory Technology Using Stacking Single Crystal Si Layers on ILD and TANOS Structure for Beyond 30 nm Node", IEDM Tech. Dig., pp 37-40, 2006*,* présente une mémoire flash NAND comportant des transistors réalisés sur deux niveaux N1 et N2, chaque niveau étant formé d'une couche active 1, 2 semi-conductrice, dans laquelle les canaux des transistors sont réalisés. Les couches actives 1 et 2 sont séparées entre elles par une couche isolante 3.

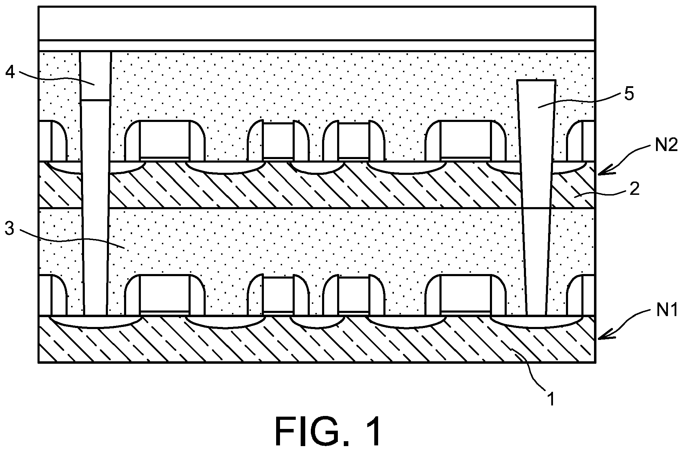

Des contacts 4, 5 traversant la couche isolante 3 peuvent être prévus pour connecter entre eux un ou des transistors réalisés sur la première couche active 1 et un ou des transistors réalisés sur la deuxième couche active 2 (figure 1).

Un tel dispositif permet d'obtenir une densité mémoire doublée sans pour autant doubler la taille de la puce.

Cependant, du fait du procédé de réalisation de la deuxième couche semi-conductrice active 2, les canaux des transistors du 2^{ème} niveau N₂ sont potentiellement de moins bonne qualité cristalline que ceux des transistors du premier niveau N₁. Par ailleurs, le procédé de réalisation d'un tel dispositif a un coût élevé dans la mesure où il nécessite un nombre élevé d'étapes de photolithographie.

Le document de H. Tanaka et al., « Bit Cost Scalable Technology with Punch and Plug Process for Ultra High Density Flash Memory », VLSI Tech Dig, p. 14-15, 2007, et celui de : Y. Fukuzumi et al., « Optimal Integration and Characteristics of Vertical Array devices for Ultra-High Density, Bit-Cost Scalable Flash Memory », IEDM 2007 Tech Dig, p. 449-452, présentent un dispositif de mémoire à canaux verticaux, orthogonaux par rapport au substrat.

La réalisation d'un tel dispositif nécessite un nombre d'étapes de photolithographie limité par rapport à celui décrit précédemment en liaison avec la figure 1. Un tel dispositif permet également d'obtenir une densité d'intégration élevée grâce à une disposition matricielle tridimensionnelle des lignes de bit et des lignes de mot.

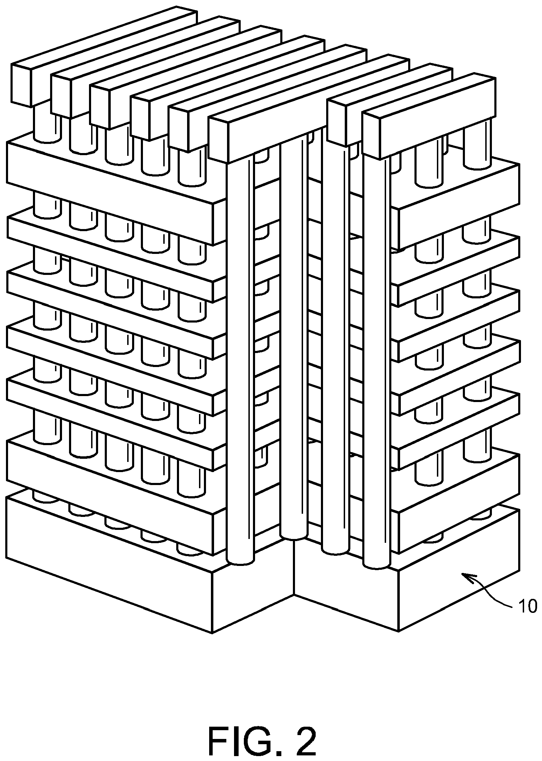

Dans un tel dispositif (figure 2), les canaux des transistors sont perpendiculaires à un substrat 10, notamment par dépôt de silicium amorphe ou polycristallin, ce qui réduit les performances électriques de la cellule mémoire par rapport à un dispositif doté de canaux en matériau semi-conducteur monocristallin.

Le procédé de réalisation d'un tel dispositif nécessite de réaliser le diélectrique de grille tunnel par dépôt ce qui rend sa qualité moins bonne que celle d'un diélectrique de grille tunnel obtenu par oxydation thermique. Par ailleurs, pour réaliser un contact électrique de bonne qualité entre la source commune et le canal d'un tel dispositif, il faut réaliser des étapes technologiques supplémentaires susceptibles de dégrader le diélectrique de grille tunnel préalablement déposé.

Le document US 2008/007635 A1 de mémoire 3D suivant l'art antérieur, et en particulier un dispositif de mémoire flash NAND avec des transistors à double-grille.

Il se pose le problème de trouver une nouvelle structure de mémoire 3D, pour laquelle, les problèmes d'encombrement sur un substrat, dans une direction parallèle à ce dernier substrat, sont d'avantage réduits, tandis que l'intégration dans une direction verticale et les performances électriques sont améliorées.

### EXPOSÉ DE L'INVENTION

Pour répondre notamment aux objectifs présentés plus haut, l'invention propose tout d'abord un dispositif microélectronique de mémoire flash selon la revendication 1.

Selon une première possibilité de mise en oeuvre, ledit empilement peut être formé d'une alternance de couches à base d'un premier matériau semi-conducteur, et de couches à base d'un deuxième matériau semi-conducteur, différent du premier matériau semi-conducteur, lesdits canaux de transistors étant formés dans ledit premier matériau semi-conducteur.

Le premier matériau semi-conducteur et le deuxième matériau semi-conducteur peuvent être des matériaux monocristallins.

Selon une possibilité de mise en oeuvre, la première couche de matériau diélectrique peut être formée par oxydation desdites couches semi-conductrices.

Cela permet de garantir une bonne qualité du diélectrique de grille tunnel et une bonne qualité d'interface entre les canaux et le diélectrique tunnel par rapport à un oxyde déposé.

La première couche de matériau diélectrique peut être formée après avoir réalisé les canaux des transistors ce qui peut permettre d'éviter d'exposer ce diélectrique à un traitement chimique risquant de le dégrader.

Selon une deuxième possibilité de mise en oeuvre du dispositif, ledit empilement peut être formé d'une alternance de couches à base d'un matériau semi-conducteur donné, et de couches à base d'un matériau isolant, lesdits canaux étant formés dans ledit matériau semi-conducteur donné.

Selon une troisième possibilité, ledit empilement peut être avantageusement formé d'une alternance de couches à base d'un matériau semi-conducteur selon une dose donnée, et de couches à base dudit matériau semi-conducteur non dopé, ou dopé selon une autre dose, différente de ladite dose donnée.

Dans ce cas, le matériau semi-conducteur peut être du Si.

Un tel empilement permet de mettre en oeuvre, dans une direction verticale, c'est-à-dire une direction orthogonale au substrat, un nombre de canaux plus important qu'avec un empilement dans lequel des matériaux semi-conducteurs différents, par exemple tel qu'un empilement de Si et de SiGe.

Le nombre de couches d'un empilement de Si et de SiGe est limité du fait des contraintes mécaniques entre les couches de Si et de SiGe.

La zone de stockage de charges peut être à base d'un matériau diélectrique tel que du SiₓN_{y} ou un autre matériau diélectrique comportant des propriétés de piégeage de charges similaires.

Selon une possibilité de mise en oeuvre, la zone de stockage de charges peut également être formée d'îlots semi-conducteurs ou métalliques encapsulés dans une couche de matériau diélectrique.

De tels îlots peuvent être par exemple à base de Si, de Ge, de SiGe, de Pt, de W, de Co, de Ni, d'Au, et peuvent être encapsulés par exemple dans une couche diélectrique à base de SiₓO_{y}, ou de SiₓN_{y}.

La zone de stockage de charges peut avoir une épaisseur comprise par exemple entre 1 nm et 15 nm.

La présente invention concerne également un procédé de réalisation d'un dispositif microélectronique de mémoire flash selon la revendication 6.

Selon une première possibilité, ledit empilement peut être formé d'une alternance de couches à base d'un premier matériau semi-conducteur, et de couches à base d'un deuxième matériau semi-conducteur, différent du premier matériau semi-conducteur, les canaux étant formés ou destinés à être formés dans le premier matériau semi-conducteur.

Selon la première possibilité, le procédé peut comprendre, entre l'étape b) et l'étape c) :
- la gravure sélective du deuxième matériau semi-conducteur vis-à-vis du premier matériau semi-conducteur, de manière à réduire la surface des couches à base du deuxième matériau semi-conducteur,
- la réalisation d'espaceurs isolants autour des couches à base du deuxième matériau semi-conducteur.

A l'aide de l'étape de gravure sélective on peut créer un surplomb des couches dans lesquelles sont fabriqués les canaux par rapport aux autres couches de l'empilement.

Le procédé microélectronique peut comprendre en outre, après l'étape d) : le dopage en surface des couches de l'empilement à base du premier matériau semi-conducteur.

Selon une deuxième possibilité, l'empilement peut être formé d'une alternance de premières couches à base d'un matériau semi-conducteur dopé selon une dose donnée, et de deuxièmes couches à base dudit matériau semi-conducteur non dopé ou dopé selon une autre dose, inférieure à ladite dose donnée.

Un tel empilement peut comporter dans une direction verticale, c'est-à-dire une direction orthogonale au substrat, un nombre important de canaux, et en particulier plus important qu'avec un empilement de matériaux semi-conducteurs différents.

Dans ce cas, le procédé microélectronique peut comprendre après l'étape b): l'oxydation préférentielle desdites premières couches vis-à-vis desdites deuxièmes couches, de manière à former un matériau isolant séparant dans l'empilement lesdites deuxièmes couches entre elles, à l'exception d'au moins une région du premier bloc dans laquelle une partie des premières couches semi-conductrices et des deuxièmes couches semi-conductrices n'est pas oxydée.

On peut ainsi réaliser une région de source commune dans le premier bloc.

Pour cela les dimensions de la région de source dans les directions parallèles au plan du substrat peuvent être prévues supérieures à deux fois la longueur maximale de retrait du matériau semi-conducteur gravé sélectivement.

Le procédé peut comprendre en outre, après l'étape b), la réalisation d'une source commune par :
- réalisation d'un masquage sur le second bloc et lesdits autres blocs, ledit masquage dévoilant ledit premier bloc,
- dopage des couches semi-conductrices dudit premier bloc.

Selon une troisième possibilité de mise en oeuvre du procédé, l'empilement peut être formé d'une alternance de couches à base d'un matériau semi-conducteur, et de couches à base d'un matériau isolant.

Le procédé peut comprendre la réalisation d'une source commune dans ledit premier bloc, la réalisation de la source commune comprenant des étapes de :
- formation d'au moins un trou dans ledit premier bloc de l'empilement à travers un masquage,
- remplissage dudit trou à l'aide d'au moins un matériau conducteur ou semi-conducteur.

Le procédé peut comprendre la réalisation d'une source commune dans ledit premier bloc, la réalisation de la source commune comprenant des étapes de :
- réalisation d'un masquage sur le second bloc et lesdits autres blocs, ledit masquage dévoilant ledit premier bloc,
- dopage des couches semi-conductrices dudit premier bloc.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 illustre un premier exemple de dispositif de mémoire flash NAND suivant l'art antérieur,
- la figure 2 illustre un deuxième exemple de dispositif de mémoire flash NAND 3D suivant l'art antérieur, comportant des transistors dont le canal est orthogonal au substrat,
- la figure 3 illustre un exemple de structure de mémoire flash NAND à 3 dimensions, suivant l'invention,
- les figures 4A et 4B illustrent un exemple de dispositif suivant l'invention, de mémoire flash NAND à 3 dimensions formée dans un empilement de couches semi-conductrices,
- la figure 5 illustre un autre exemple de dispositif de mémoire flash NAND à 3 dimensions, formée dans un empilement de couches comportant une alternance de couches semi-conductrices et de couches isolantes,
- les figures 6A-6D, 7A-7O, 8A-8E illustrent un premier exemple de procédé de réalisation suivant l'invention d'un dispositif microélectronique de mémoire flash NAND à 3 dimensions,
- les figures 9A, 10A-10D, 11A-11C illustrent un deuxième exemple de procédé de réalisation suivant l'invention, d'un dispositif microélectronique de mémoire flash NAND à 3 dimensions,
- les figures 12A-12C, 13A illustrent un troisième exemple de procédé de réalisation suivant l'invention d'un dispositif microélectronique de mémoire flash NAND à 3 dimensions,
- la figure 14 illustre un autre exemple de dispositif de mémoire flash NAND à 3 dimensions, chaque canal est commandé par deux grilles de contrôle indépendantes,
- la figure 15 illustre un exemple de schéma électrique équivalent d'un dispositif de mémoire flash NAND à 3 dimensions, suivant l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

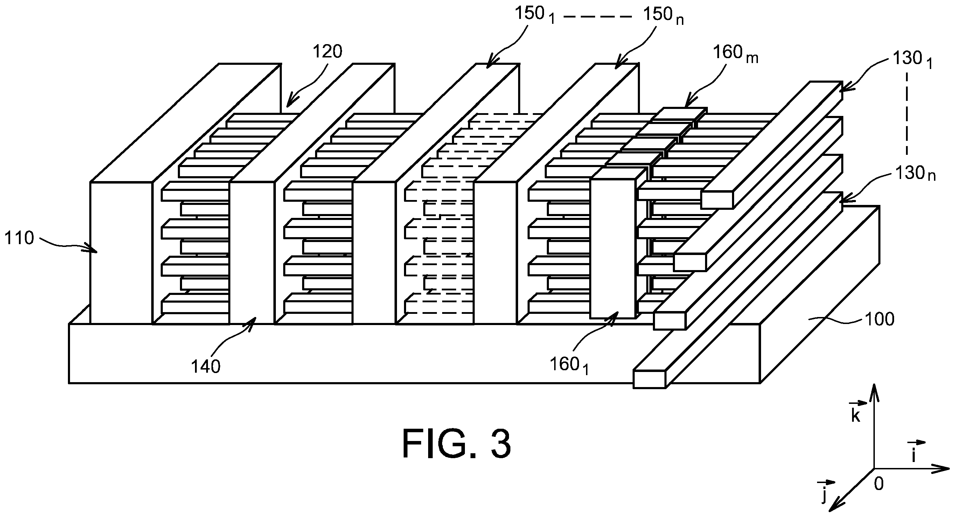

Un exemple de dispositif microélectronique de mémoire à 3 dimensions, va à présent être décrit en liaison avec la figure 3.

Cette mémoire peut être dotée de m*n*p points mémoires ou cellules mémoires et peut être de type flash, c'est-à-dire une mémoire à semi-conducteur, réinscriptible, possédant les caractéristiques d'une mémoire vive, mais dont les données ne disparaissent pas lors d'une mise hors tension.

Ainsi, la mémoire flash stocke un ou des bits de données dans des cellules de mémoire, ces données étant conservées en mémoire lorsque l'alimentation électrique de la mémoire est coupée.

La mémoire, peut avoir une architecture similaire à celle d'une mémoire flash de type NAND.

Les mémoires FLASH de type NAND sont accessibles par bloc et offrent une très forte densité de points mémoires par unité de surface dans la mesure où elles nécessitent peu d'interconnexions.

Le dispositif comprend tout d'abord un substrat 100, qui peut être de type semi-conducteur sur isolant, par exemple de type SOI (SOI pour « Silicon On Insulator ») ou être un substrat semi-conducteur massif (« bulk » selon la terminologie anglo-saxonne).

Le substrat 100 sert de support à un premier bloc 110 semi-conducteur formant une source commune à plusieurs transistors.

Des barreaux semi-conducteurs 120 parallèles au plan principal du substrat (le plan principal du substrat étant défini sur la figure 3 comme un plan passant par le substrat 100 et parallèle au plan [o;*̅i̅*̅;*̅j̅*̅] d'un repère orthogonal [o*;i̅;j̅;k̅*]) relient chacun dans le sens de leur longueur le bloc de source commune 110 avec une zone de contact connectée à une ligne conductrice appelée ligne de bit.

Ces barreaux semi-conducteurs 120 sont destinés à former des canaux desdits transistors. Les barreaux semi-conducteurs 120 destinés à former des canaux desdits transistors peuvent être séparés entre eux par d'autres barreaux (non représentés sur la figure 3), ces autres barreaux étant isolants ou à base d'un matériau semi-conducteur différent, ou à base du même matériau mais ayant un dopage plus faible ou n'étant pas dopés.

Les barreaux semi-conducteurs 120 peuvent être agencés selon une matrice, comportant p (avec p ≥1) rangées verticales de barreaux parallèles entre eux et m (avec m ≥ 1) rangées horizontales de barreaux parallèles entre eux.

Par « verticale », on entend une direction orthogonale ou sensiblement orthogonale au plan principal du substrat, tandis que par « horizontale », on entend une direction parallèle ou sensiblement parallèle au plan principal du substrat.

La longueur Lb des barreaux 120, peut être prévue de sorte que Lb = (n+3)*dg + (n+2)*Lg, avec n un nombre de grilles de contrôle, dg l'espacement entre deux grilles voisines et Lg la longueur d'une grille (définie dans une direction parallèle au vecteur *̅i̅*̅ du repère orthogonal [o*;i̅;j̅;k̅*]). L'espacement dg et la longueur Lg peuvent être compris par exemple entre 5 nanomètres et 500 nanomètres, ou être par exemple de l'ordre de 50 nanomètres.

Les barreaux peuvent être espacés entre eux d'une distance db, comprise par exemple entre 5 et 500 nanomètres, par exemple de l'ordre de 100 nanomètres.

Les barreaux 120 d'une même rangée horizontale de la matrice peuvent être connectés à une même ligne de bit.

Dans cet exemple, le dispositif comporte un nombre p de lignes de bits conductrices 130₁, ..., 130ₚ.

Le dispositif comporte également une première grille 140 de sélection sous forme d'un bloc qui, dans cet exemple, enrobe l'ensemble des barreaux 120 et permet de contrôler la conduction de ces derniers.

Le dispositif peut également comprendre une pluralité de n grilles de contrôle 150₁, ..., 150ₙ, respectivement sous forme d'un bloc de matériau de grille qui enrobe chacun des barreaux 120 de la structure.

Au niveau de chacune des grilles de contrôle, une couche de diélectrique de grille (non représentée sur cette figure) est en contact avec les barreaux 120. Une zone de stockage de charges (non représentée sur cette figure), par exemple de stockage de charges, est également prévue et repose sur la couche de diélectrique de grille. Une autre couche diélectrique est prévue entre le matériau de grille et ladite zone de stockage de charges.

Le dispositif comprend une pluralité de deuxièmes grilles de sélection.

Dans cet exemple, le dispositif comporte m deuxièmes grilles 160₁,... 160ₘ de sélection, respectivement sous forme d'un bloc qui enrobe chacun des barreaux 120 d'une même rangée verticale de la matrice de barreaux.

Le matériau des grilles 140, 150₁,..., 150ₙ, 160₁, ..., 160ₘ, peut être semi-conducteur tel que par exemple du polysilicium ou métallique, tel que par exemple du TiN, du W, du polysilicium siliciuré, du TaN, du Pt, du PtSi ou une combinaison de ces matériaux.

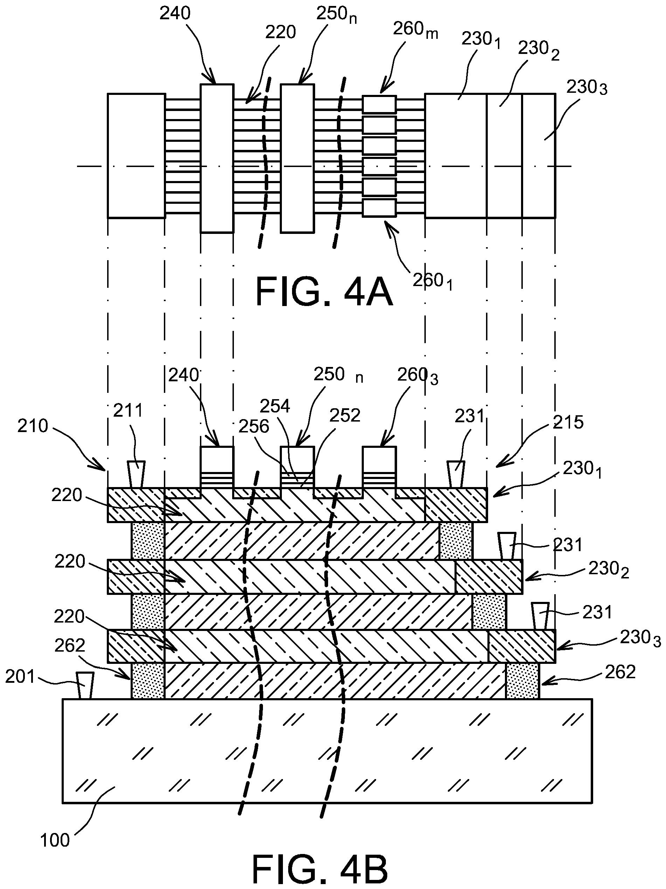

Les figures 4A et 4B illustrent un exemple de dispositif microélectronique de mémoire flash, semblable à celui qui vient d'être décrit avec n grilles de contrôle 250₁,..., 250ₙ (une seule grille de contrôle 250ₙ étant représentée sur ces figures) et p (avec dans cet exemple p = 3) lignes de bits 230₁, 230₂,..., 230₃.

Sur la figure 4A, une vue de dessus du dispositif est donnée, tandis que sur la figure 4B, ce dispositif est représenté selon une vue en coupe transversale.

Le dispositif est réalisé dans un empilement de couches gravées.

Dans cet exemple, l'empilement peut être formé d'une alternance de couches semi-conductrices différentes de par le matériau semi-conducteur à base duquel elles sont formées.

Cet empilement peut être formé d'une alternance de matériaux semi-conducteurs, par exemple d'un premier matériau semi-conducteur tel que du Si, et d'un deuxième matériau semi-conducteur, tel que du SiGe.

Selon une variante, cet empilement peut être formé d'une alternance de matériaux semi-conducteurs, par exemple d'un premier matériau semi-conducteur tel que du Si, qui est dopé ou fortement dopé par exemple dopé avec des atomes de phosphore, et du même matériau semi-conducteur, tel que mais qui n'est pas dopé ou qui est dopé selon une dose plus faible.

Cet empilement comporte un bloc 210 de source commune qui, dans cet exemple, est un bloc semi-conducteur fortement dopé, par exemple dopé N+. Une zone de contact 211 peut être prévue sur le bloc 210 de source commune.

Des barreaux 220 formés chacun dans l'empilement 202 de matériaux semi-conducteurs relient le bloc 210 de source commune à des zones d'un deuxième bloc 215 de l'empilement, prévues pour le contact à des lignes de bits. Les barreaux 220 sont prévus pour former des canaux de transistors. Dans cet exemple, les canaux sont partiellement désertés. Un contact 201 communément appelé « body » peut être prévu par le substrat 100. La prise de contact 201 body peut être réalisée de manière conventionnelle comme une prise de caisson en face avant du substrat. Un tel contact 201 peut permettre d'effacer l'ensemble du plan mémoire.

Dans cet exemple, les barreaux peuvent être prévus avec une largeur W supérieure à 2 fois la profondeur de déplétion dans les barreaux. Par exemple, dans le cas de barreaux à base de Si dopé de type P selon un dopage d'atomes de Bore par exemple de l'ordre de 10¹⁸ cm⁻³, une largeur de barreau supérieure à 2*25 nanomètres, par exemple de l'ordre de 80 nanomètres peut être prévue.

Des grilles 250₁,..., 250ₙ de contrôle reposent sur un empilement tri-couches formé d'une couche isolante 256, d'une couche 254 de stockage d'électrons et d'une couche de diélectrique 252 de grille.

La couche de diélectrique 252 de grille, ainsi que la couche isolante 256 en contact avec le matériau de grille, peuvent être par exemple à base de SiO₂. La zone de stockage 254 des électrons peut être par exemple à base de SixNy ou un autre matériau diélectrique similaire ayant également des propriétés de piégeage de charges. La couche 254 de stockage de charges peut également être formée d'îlots semi-conducteurs ou métalliques encapsulés dans une matrice diélectrique, tels que des îlots de Si, de Ge, de SiGe, de Pt, de W, de Co, de Ni, de Au, dans une matrice de SixOy, ou de SixNy.

La couche 254 de stockage des électrons peut avoir une épaisseur comprise par exemple entre 1 nanomètre et 15 nanomètres ou par exemple de l'ordre de 5 nanomètres.

Dans cet exemple, le dispositif comporte m deuxièmes grilles 260₁,... 260ₘ de sélection (la grille 260₃ étant représentée sur la vue en coupe de la figure 4B).

Cet empilement comprend un bloc 215 gravé comportant un profil en escaliers avec des marches prévues pour des zones de prises de contacts 231, par exemple à base de matériau semi-conducteur dopé, avec des lignes de bits 230₁, 230₂,..., 230ₚ. Ces zones de contacts 231 sont situées aux extrémités des barreaux 220 semi-conducteurs. Des espaceurs isolants 262 sont prévus pour isoler les barreaux semi-conducteurs 220 entre eux, et les lignes de bits 230₁, 230₂,..., 230ₚ entre elles.

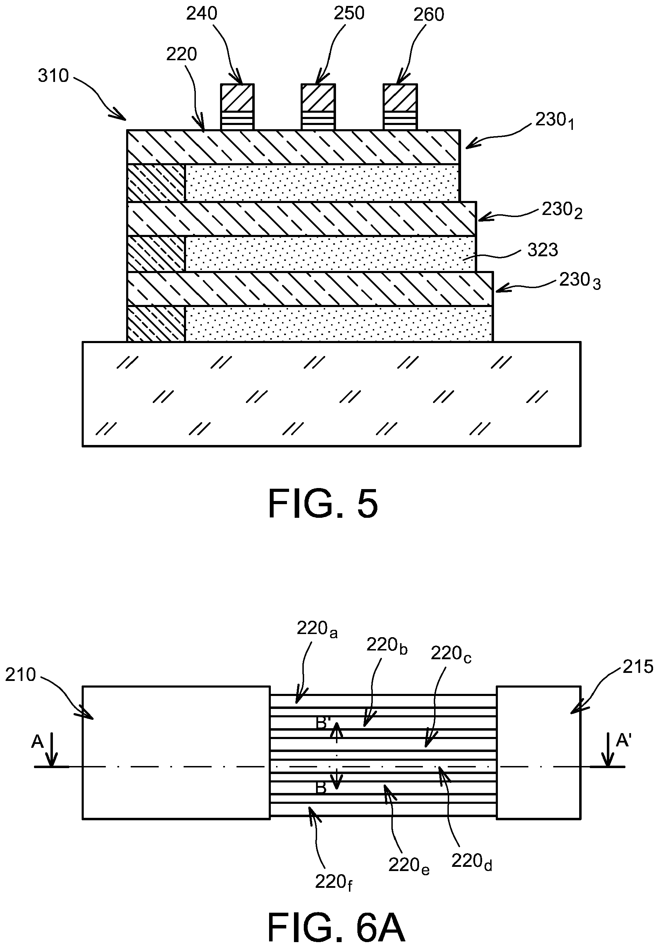

Sur la figure 5, une variante du dispositif précédemment décrit, est donnée. Les barreaux semi-conducteurs agencés en matrice, sont cette fois séparés et isolés entre eux par un matériau diélectrique 323, par exemple tel que du SiO₂.

Un bloc de source commune 310, peut quant à lui être à base de matériau semi-conducteur et formé d'une alternance de couches semi-conductrices, non dopées, par exemple à base de Si, et de couches semi-conductrices dopées, par exemple à base de Si dopé au phosphore.

Selon une possibilité, un tel dispositif peut être prévu avec des canaux complètement désertés. Dans ce cas, l'effacement de la mémoire peut être réalisé ligne de mot par ligne de mot. Une ligne de mot correspond à l'ensemble des points mémoires partageant la même grille de contrôle.

Selon une variante (non représentée) le bloc de source commune 310, peut être formé d'une zone conductrice ou semi-conductrice insérée dans l'empilement de couches.

Un exemple de procédé de réalisation d'un dispositif microélectronique suivant l'invention, du type de celui décrit précédemment en liaison avec les figures 4A-4B, va à présent être donné.

Dans cet exemple, un dispositif avec un nombre p de lignes de bits tel que p=4, et avec un nombre n=6 de rangées verticales, est donné. Une mémoire suivant l'invention n'est pas limitée à un tel nombre de lignes de bits ni à un tel nombre de rangées verticales.

La première étape de ce procédé consiste à réaliser un empilement 202 de couches minces semi-conductrices sur un substrat 200, qui peut être par exemple un substrat massif à base de silicium de type P.

L'empilement 202 est formé de couches 204₁,...,204₈ semi-conductrices, qui peuvent être réalisées par exemple, par plusieurs épitaxies successives à partir du substrat 200.

L'empilement 202 peut être formé d'une alternance de couches semi-conductrices, comportant des couches 204₂, 204₄,..., 204₈, à base d'un premier matériau semi-conducteur 206, qui peut être semi-conducteur, tel que par exemple du Si éventuellement dopé, par exemple dopé au bore, et des couches notées 204₁, 204₃,..., 204₇ à base d'un deuxième matériau semi-conducteur 207, différent du premier matériau semi-conducteur 206.

Le deuxième matériau semi-conducteur 207 peut être un matériau susceptible de pouvoir être gravé de manière sélective vis-à-vis du premier matériau semi-conducteur 206. Le deuxième matériau semi-conducteur 207 peut être par exemple du SiGe, éventuellement dopé au bore.

Dans cet exemple de réalisation, le premier matériau semi-conducteur 206 et le deuxième matériau semi-conducteur 207 peuvent être dopés in-situ pendant l'épitaxie. Les matériaux semi-conducteurs 206 et 207 sont dopés selon un même type de dopage. Selon une variante, les matériaux semi-conducteurs 206 et 207 peuvent être dopés N.

Les couches 204₂,..., 204₈, à base du premier matériau 206 peuvent avoir une épaisseur e₁, comprise par exemple entre 5 nanomètres et 300 nanomètres.

Les couches 204₁,..., 204₇, à base du deuxième matériau 207, peuvent, quant à elles, avoir une épaisseur e₂, par exemple entre 5 nanomètres et 300 nanomètres.

Une fois l'empilement 202 réalisé, on effectue le dépôt d'une couche protectrice 209, par exemple à base de SiₓN_{y}, destinée à protéger l'empilement 202 d'une gravure telle que, par exemple, une gravure plasma. Ensuite, on dépose une couche de résine photosensible (non représentée), par exemple à base de polyimide, sur la couche protectrice 209, et l'on définit dans la couche de résine, par exemple par photolithographie, un masque de résine comportant une pluralité de motifs. Ensuite, on effectue une gravure anisotrope de la couche protectrice 209 protégée par le masque de résine.

On procède ensuite à une première étape de gravure des couches 204₁,..., 204₈, situées sous la couche protectrice 209, afin de reproduire les motifs de ce dernier dans l'empilement 202. La gravure peut être de type anisotrope, et réalisée par exemple à l'aide d'un plasma à base de CF₄, HBr, O₂.

Sur la figure 6A, l'empilement 202 une fois gravé, est représenté selon une vue de dessus.

Cet empilement 202 gravé, comporte un premier bloc 210 dans lequel une région de source commune à plusieurs transistors est destinée à être réalisée, un second bloc 215 dans lequel des régions de drain et des zones de prises de contact sur ces régions de drain sont destinées à être réalisées, ainsi qu'une pluralité de blocs 220a, 220b, 220c, 220d, 220e, 220f, de forme allongée, distincts, reliant le premier bloc 210 et le deuxième bloc 215.

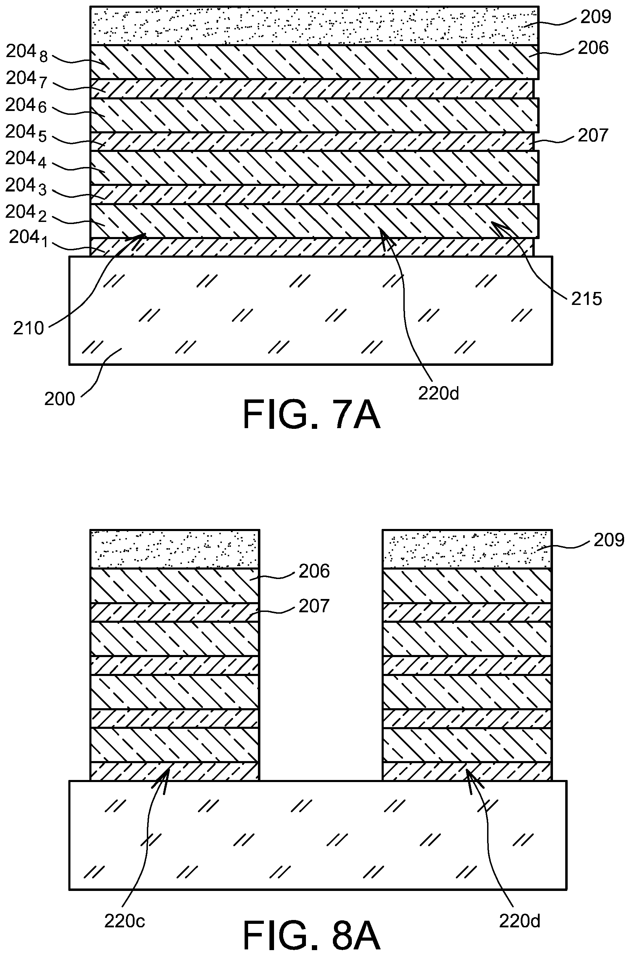

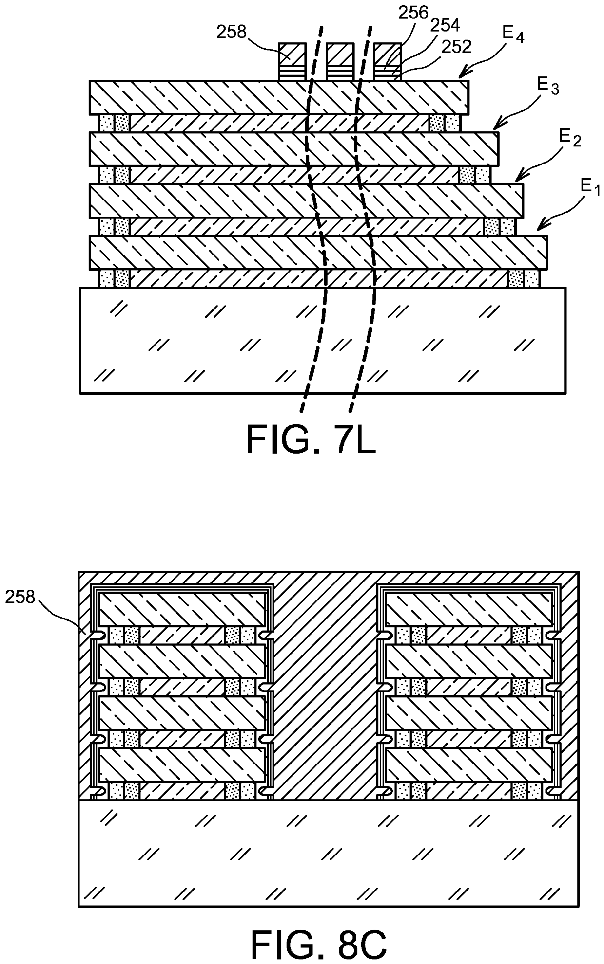

Sur les figures 7A et 8A, le même empilement 202 est représenté, respectivement, selon une première vue en coupe transversale A'A, et selon une deuxième vue en coupe transversale B'B (les coupes A'A et B'B étant toutes les deux indiquées sur la figure 6A).

Ensuite, on forme un profil en escalier dans le deuxième bloc 215 de l'empilement 202. On crée ainsi des marches dans le second bloc 215 formant des emplacements pour de futurs contacts avec les couches semi-conductrices 204₈, 204₆, 204₄, 204₂.

Pour cela, on forme tout d'abord un masque de résine 240, dévoilant une partie de la couche protectrice 209 située sur le second bloc 215.

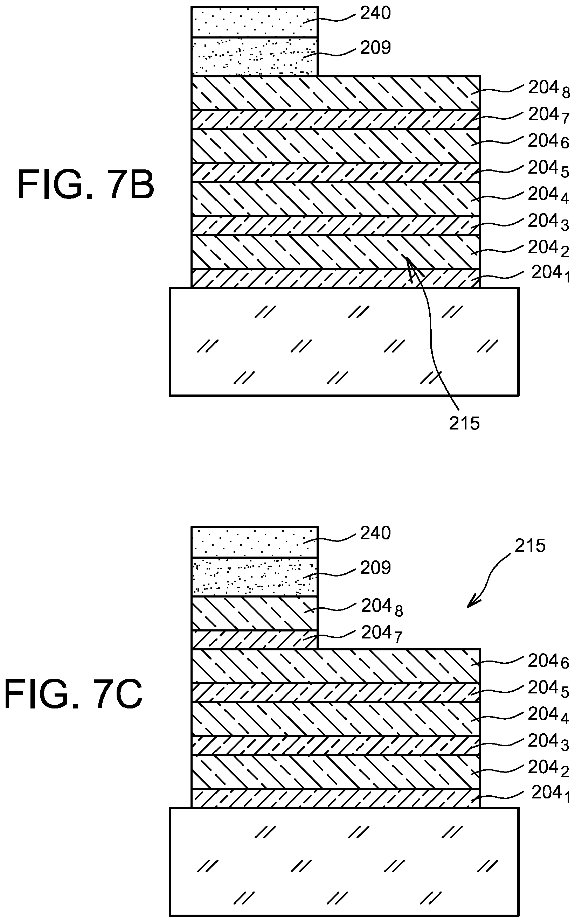

On retire ensuite une partie de la couche protectrice 209 située sur le second bloc 215, de manière à dévoiler, au niveau du second bloc 215 une portion de la couche supérieure 204₈ de l'empilement 202 de couches semi-conductrices (figure 7B).

Puis, une portion des deux couches supérieures 204₈, 204₇, de l'empilement 202 est retirée à l'extrémité du deuxième bloc 215. De cette manière on forme une première marche du profil en escaliers.

Pour cela, on grave, par exemple à l'aide d'une gravure plasma anisotrope, une portion dévoilée de la couche supérieure 204₈ de l'empilement 202, ainsi qu'une portion de la couche de l'empilement 202 située sous ladite portion de la couche supérieure 204₈.

Une fois ce retrait effectué, une portion d'une couche 204₆ de l'empilement est dévoilée et forme un emplacement d'une prise de contact avec la couche semi-conductrice 204₆ (figure 7C).

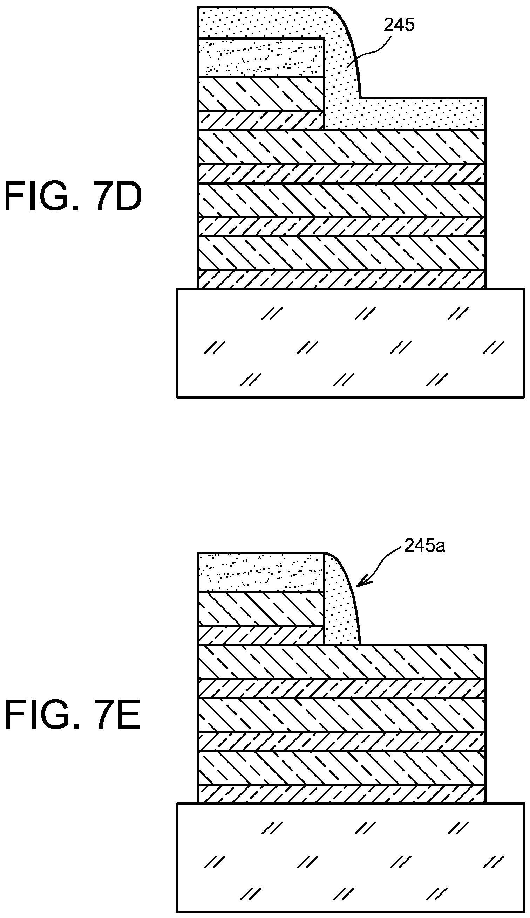

Ensuite, on effectue un dépôt d'une couche isolante 245 sur l'empilement (figure 7D).

Puis, on grave cette couche isolante 245 de manière à conserver un premier bloc isolant 245a issu de cette couche isolante, prévu avec la couche protectrice 209, pour masquer les couches semi-conductrices 204₈ et 204₇ de l'empilement, et protéger ces dernières d'une gravure ultérieure (figure 7E).

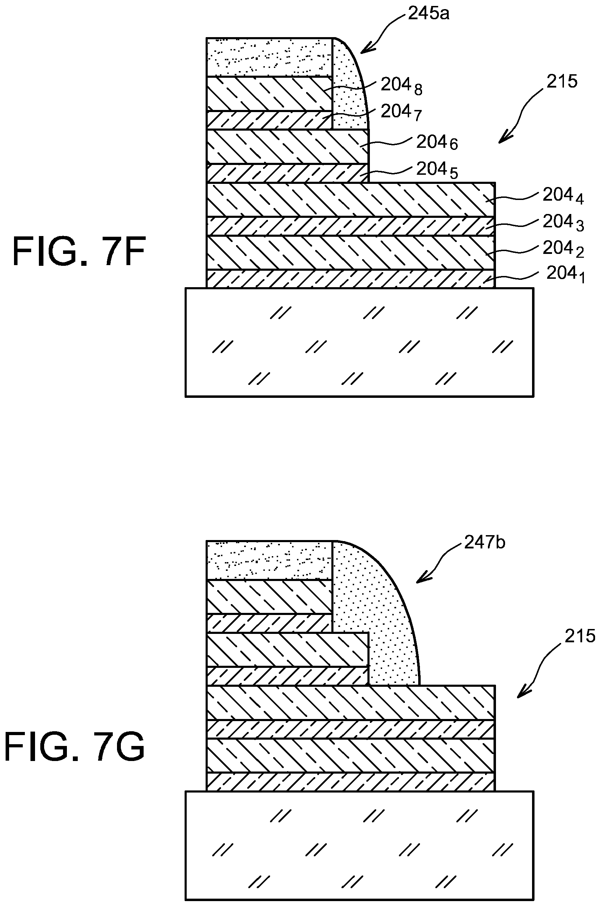

On retire ensuite une portion dévoilée des deux couches 204₆ et 204₄ suivantes de l'empilement, située à une extrémité du second bloc 215. De cette manière, on forme une deuxième marche du profil en escaliers (figure 7F).

Ensuite, on effectue un dépôt d'une autre couche isolante, puis, on grave cette autre couche isolante de manière à laisser un autre bloc isolant 247b formé par-dessus le bloc isolant 245a, et destiné, avec la couche protectrice 209, à masquer les couches semi-conductrices 204₈, 204₇, 204₆ et 204₅ (figure 7G).

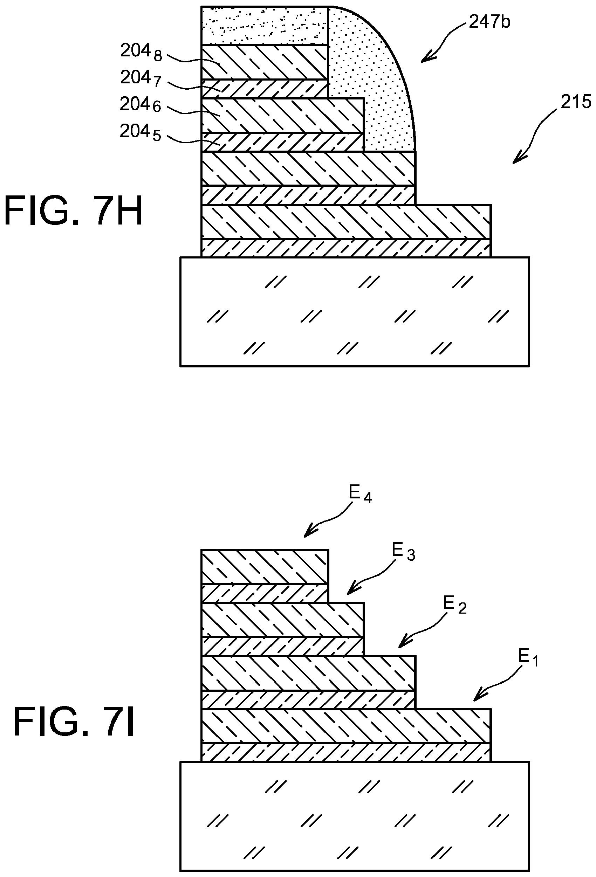

Puis, une portion des couches 204₄, 204₃, de l'empilement 202 est retirée à l'extrémité du deuxième bloc 215. De cette manière on forme une troisième et une quatrième marche du profil en escaliers E1, E2, E3, E4 (figure 7H).

Pour former un profil en escaliers comportant p marches à partir d'un empilement comprenant 2p couches semi-conductrices, on répète un nombre de fois nécessaire les étapes qui viennent d'être données.

Ensuite, on effectue un retrait du bloc isolant 247b, et de la couche protectrice 209 à l'aide d'une gravure anisotrope sélective, par exemple à base de H₃PO₄ afin de dévoiler les escaliers E1, E2, E3, E4 (figure 7I).

Selon un autre exemple de réalisation du profil en escalier E1, E2, E3, E4 réalisé dans le deuxième bloc 215, les marches peuvent être réalisées par réductions successives (« trimming » selon la terminologie anglo-saxonne) d'un masque de résine.

Dans l'exemple décrit sur la figure 7I, un profil en escalier à 4 marches comportant 4 niveaux de barreaux empilés a été effectué. Des emplacements de prises de contacts ont ainsi été formés (figure 7I).

Il est toutefois possible suivant le nombre de couches semi-conductrices prévues dans l'empilement 202, de réaliser un profil en escalier avec un nombre plus élevé de marches.

Ensuite, on forme des espaceurs isolants autour des couches de l'empilement 202 qui sont à base du deuxième matériau semi-conducteur 207.

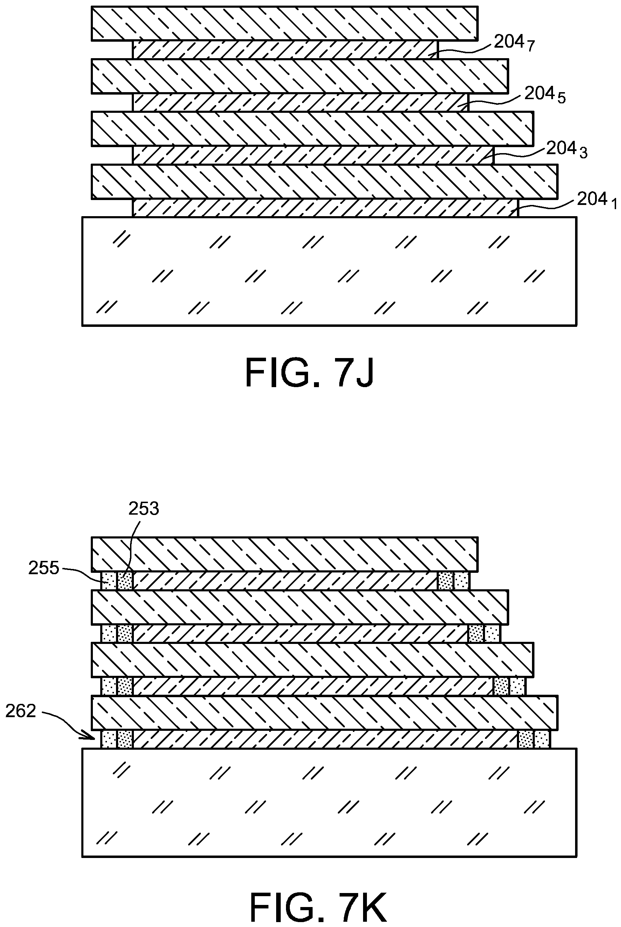

Pour cela, on effectue une gravure de l'empilement 202, isotrope, et sélective, de manière à retirer partiellement les couches 204₁, 204₃,..., 204₇, de l'empilement 202 qui sont à base du deuxième matériau semi-conducteur 207, par exemple à base de SiGe. La gravure peut être une gravure isotrope du deuxième matériau semi-conducteur 207, sélective vis-à-vis du premier matériau semi-conducteur 206, par exemple du Si. Une telle gravure peut être réalisée par exemple à l'aide d'un plasma à base de fluor, par exemple à base de CF₄, dans un cas où le deuxième matériau semi-conducteur 207 est du SiGe (figure 7J).

La gravure permet d'effectuer un retrait de portions des couches 204₁,..., 204₇, à base du deuxième matériau 207 semi-conducteur, de part et d'autre de la l'empilement 202, au niveau des flancs ou faces latérales de ce dernier. De manière préférable, l'étape de gravure sélective impacte les couches 204₁,..., 204₇ à base du deuxième matériau semi-conducteur 207 et laisse les autres couches intactes.

Comme le montre la figure 7J, représentant une vue en coupe de l'empilement, les couches gravées 204₁, 204₃,..., 204₇, à base du deuxième matériau semi-conducteur 207, ont des étendues inférieures à celles des autres couches 204₂, 204₄,..., 204₈, à base du premier matériau semi-conducteur 206.

Il résulte, à la suite de la gravure, que l'empilement 202 comporte sur ses flancs, ou sur chacune de ses faces latérales, un profil en créneau.

Ensuite, on forme sur les flancs ou faces latérales, des zones isolantes ou espaceurs isolants 262 (« spacers » selon la terminologie anglo-saxonne), de manière à combler au moins partiellement les parties des couches 204₁,..., 204₇, qui ont été retirées par gravure sélective de l'empilement 202.

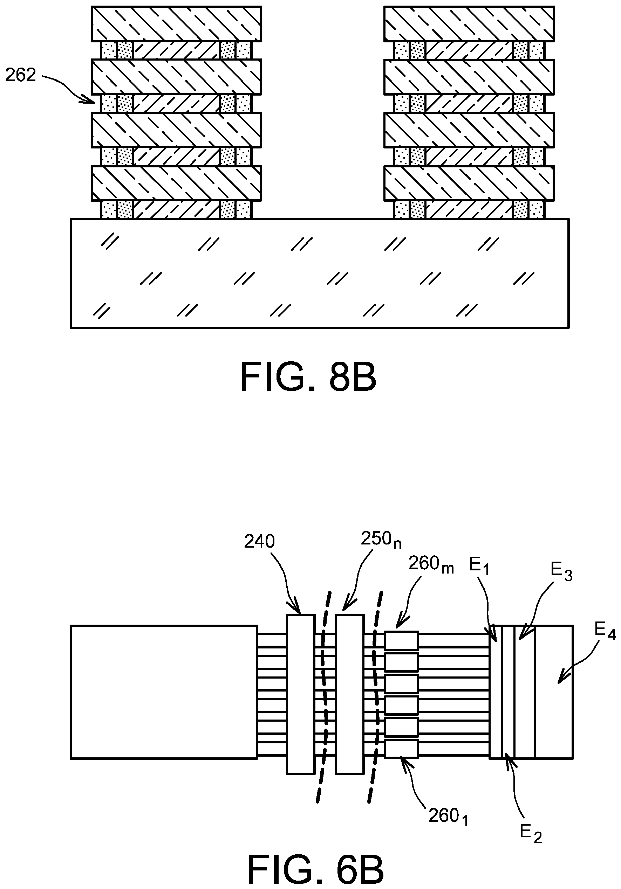

La formation de ces espaceurs 262 isolants peut être réalisée tout d'abord par un dépôt d'une première couche isolante 253, par exemple à base de SiO₂ puis d'une deuxième couche isolante 255, par exemple à base de SixNy, puis, une gravure partielle, isotrope, de la deuxième puis de la première couches isolantes 253, 255 déposées. Cette gravure partielle est réalisée de manière à ne conserver les couches isolantes 253, et 255, de préférence qu'autour des parties retirées des couches 204₁,..., 204₇, à base du deuxième matériau semi-conducteur 207. L'épaisseur restante des couches isolantes 253, 255, forme alors des espaceurs isolants 262 de part et d'autre de l'empilement, sur les flancs ou faces latérales de ce dernier (figures 7K et 8B, le même empilement 202 étant représenté, sur ces figures respectivement, selon une vue en coupe longitudinale A'A, et selon une vue en coupe transversale B'B).

Ensuite, on recouvre l'empilement 202 d'un tri-couches 252, 254, 256, par exemple un tri-couches ONO (ONO pour « Oxyde Nitrure Oxyde »). Le tri-couches est formé d'une couche de diélectrique 252 de grille, par exemple à base de SiO₂, puis d'une couche 254 dite de stockage de charges, prévue selon une épaisseur et un matériau, favorables au piégeage de charges. La couche 254 de stockage peut être par exemple à base de SiₓN_{y} ou d'un autre matériau diélectrique ayant des propriétés de piégeage de charges similaires.

La zone de stockage de charges peut également être formée d'îlots semi-conducteurs ou métalliques encapsulés dans une matrice diélectrique, tels que des îlots de Si, de Ge, de SiGe, de Pt, de W, de Co, de Ni, d'Au, dans une couche par exemple à base de SiₓO_{y}, ou de SiₓN_{y}. Ensuite, on dépose une autre couche isolante 256 par-dessus la couche 254. La couche isolante 256 peut être par exemple à base de SiO₂.

Puis, on dépose un matériau 258 de grille, qui peut être semi-conducteur tel que par exemple du polysilicium ou métallique, tel que par exemple du TiN, du W, du polysilicium siliciuré, du TaN, du Pt, du PtSi ou une combinaison de ces matériaux.

Un polissage mécanico-chimique (CMP pour « Chemical mechanical planarisation ») peut ensuite être effectué.

Puis, on forme des motifs de grille, par photolithographie puis gravure du matériau 258 de grille et des couches isolantes 252, 254, 256 (figures 6B, 7L et 8C, le même empilement étant représenté sur ces figures respectivement, selon une vue de dessus, selon une vue en coupe A'A et selon une vue en coupe transversale B'B).

Plusieurs grilles de contrôle 250₁,..., 250n et plusieurs grilles de sélection 260₁, 260ₘ peuvent être formées (sur les figures 6B, 7L, et 8C, seule 1 grille de contrôle 250n parmi plusieurs grilles de contrôle étant représentée).

Ensuite, on effectue un dopage superficiel des couches 204₂, 204₄, 204₆, 204₈, de l'empilement 202.

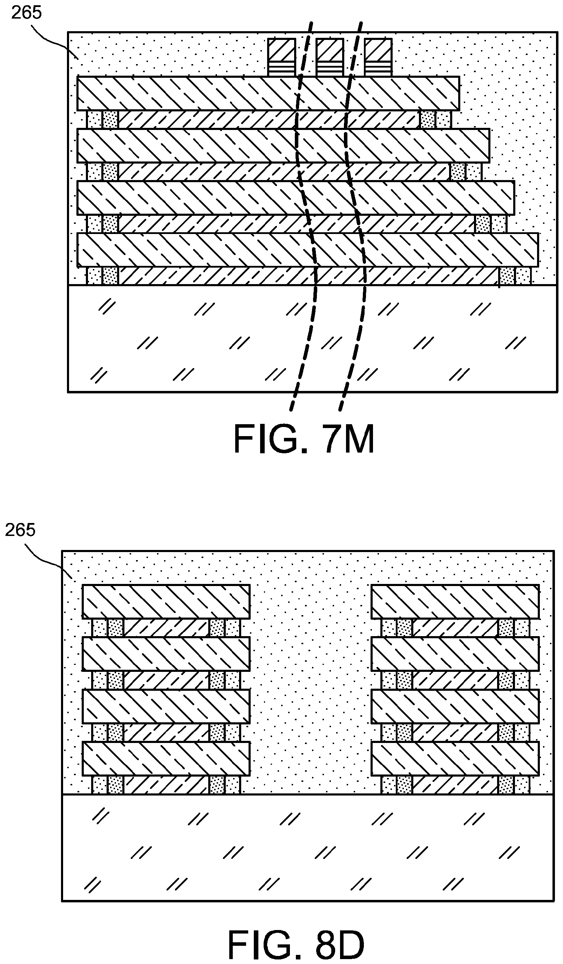

Ce dopage peut être effectué par exemple par diffusion, par exemple en déposant un matériau isolant dopé tel qu'un oxyde 265 SiₓO_{y} dopé. L'oxyde dopé peut être prévu pour doper les couches semi-conductrices 204₂, 204₄, 204₆, 204₈, par exemple selon un dopage N+ (figures 7M, et 8D, le même empilement étant représenté sur ces figures, respectivement, selon une vue en coupe longitudinale A'A, et selon une vue en coupe transversale B'B). Les espaceurs 262 réalisés précédemment permettent alors de bloquer la diffusion des dopants afin de ne pas doper le deuxième matériau semi-conducteur 207. Ce dopage superficiel est réalisé de sorte que seul le premier matériau semi-conducteur 206 est dopé N+ ou P+ sur une profondeur LD_Si, par exemple comprise entre 5 nanomètres et 200 nm, ou par exemple de l'ordre de 30 nm.

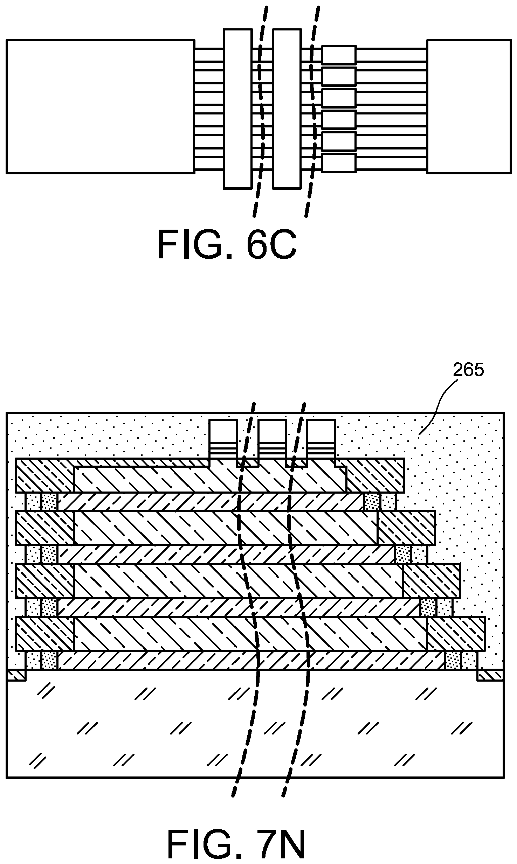

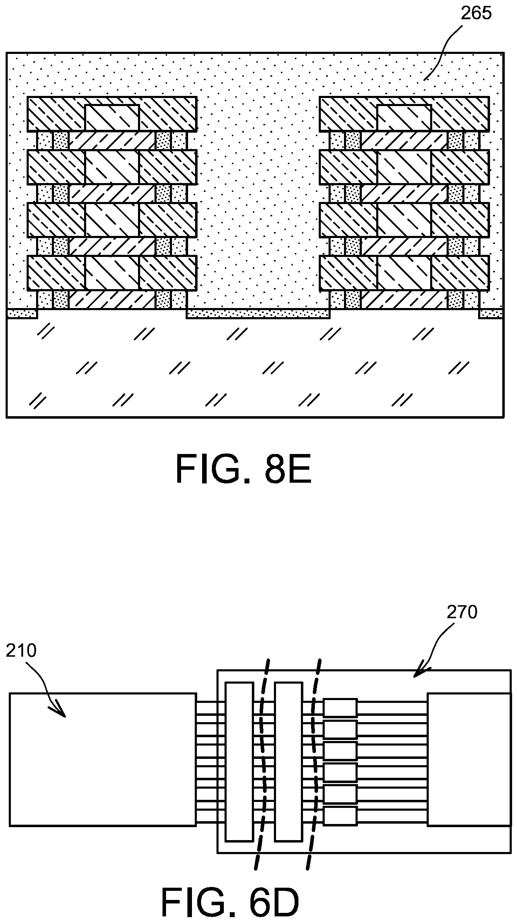

Des lignes de bits, destinées à être formées sur les zones E1, E2, E3, E4 seront isolées les unes des autres par les espaceurs internes et éventuellement par le deuxième matériau semi-conducteur 207 (figures 7N, et 8E, le même empilement 202 étant représenté, sur ces figures respectivement, selon une vue en coupe transversale A'A, et selon une vue en coupe transversale B'B indiquées sur la figure 6C).

Selon une variante possible, l'étape de dopage peut être réalisée à l'aide d'un plasma (dopage de type PLAD), afin de réaliser un dopage à faible profondeur, c'est-à-dire une profondeur qui peut être comprise entre 5 nanomètres et 80 nanomètres, par exemple de l'ordre de 20 nm.

Ensuite, on forme une source commune dans le premier bloc 210.

Pour cela, on forme une couche de résine sur la couche 265 d'oxyde, puis un masque 270 de résine à partir de cette couche de résine. Le masque 270 de résine est formé de manière à dévoiler l'empilement 202 au niveau du premier bloc 210. On retire ensuite une partie de la couche 265 d'oxyde qui n'est pas protégée par le masque 270 de résine. Pour cela, on effectue une gravure, par exemple anisotrope, de l'oxyde 265 dopé. Cette gravure peut être réalisée par exemple à l'aide d'un plasma.

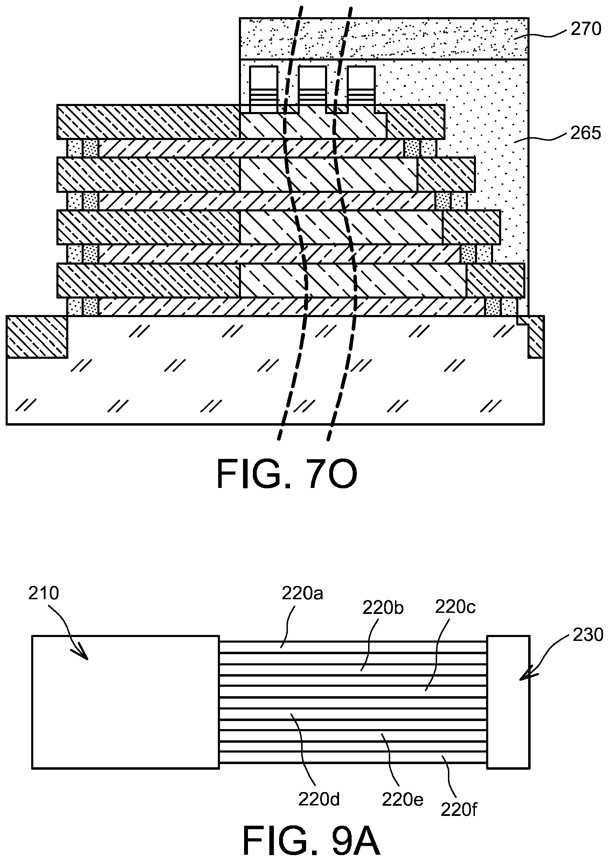

Ensuite, on forme dans le bloc 210, une source commune en dopant ce bloc 210, par exemple par implantation N+ ou P+ (figure 7O).

Selon une variante de l'exemple de procédé qui vient d'être décrit, un empilement de couches semi-conductrices peut être formé d'une alternance de couches semi-conductrices, comportant des couches 304₀, 304₂, 304₄,..., 304₇, à base d'un matériau semi-conducteur, qui peut être semi-conducteur, par exemple tel que du Si, et qui est fortement dopé par exemple dopé avec des atomes de phosphore, et des couches notées 304₁, 304₃,..., 304₇, à base du même matériau semi-conducteur, par exemple du Si, mais qui n'est pas dopé ou qui est dopé selon une dose plus faible que celle des couches 304₀, 304₂, 304₄,..., 304₇.

Ensuite, on forme le premier bloc 210, le deuxième bloc 230 et les blocs 220a, 220b, 220c, 220d, 220e distincts et de forme allongée reliant le premier bloc 210 et le deuxième bloc 215, par gravure, par exemple à l'aide d'un plasma à base de CF₄, HBr, O₂, de l'empilement 202 à travers un masque dur 309, (figures 9A, 10A et 11A, le même empilement 202 étant représenté, sur ces figures respectivement, selon une vue de dessus, selon une vue en coupe A'A indiquée sur la figure 9A, et selon une autre vue en coupe B'B indiquée sur la figure 9A).

Ensuite, on forme un profil en escalier à l'extrémité du bloc 230, afin de former des zones de prises de contacts de lignes de bits.

Ensuite, dans le deuxième bloc 215 et dans les blocs 220a, 220b, 220c, 220d, 220e, on isole électriquement les couches 304₁, 304₃, 304₅, 304₇ les unes des autres.

Cette étape peut être réalisée par oxydation des couches 304₀,..., 304₆. L'oxydation peut être une oxydation préférentielle des couches semi-conductrices 304₀, ..., 304₆, par exemple à base de Si fortement dopé par rapport aux couches 304₁,...,304₇ semi-conductrices par exemple à base de Si faiblement dopé ou non dopé.

Par oxydation préférentielle, on entend que les couches 304₀, 304₄, 304₆, à base de silicium fortement dopé ont davantage tendance à s'oxyder et plus rapidement que celles 304₁,...,304₇ qui sont moins dopées ou pas dopées.

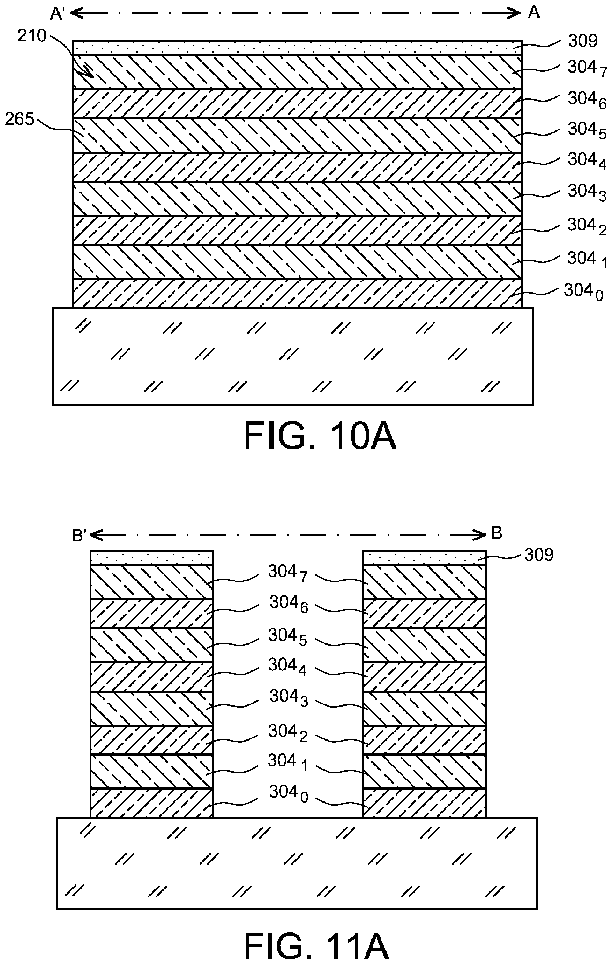

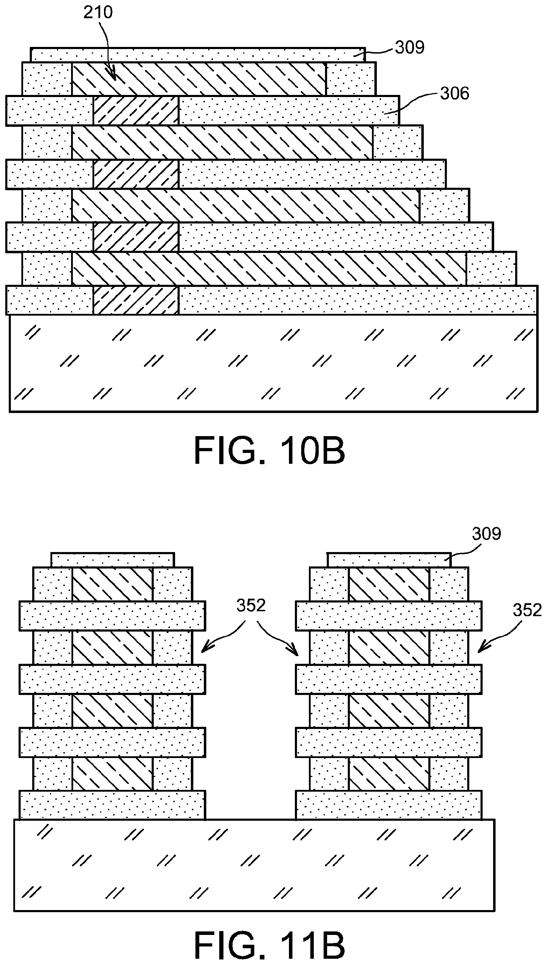

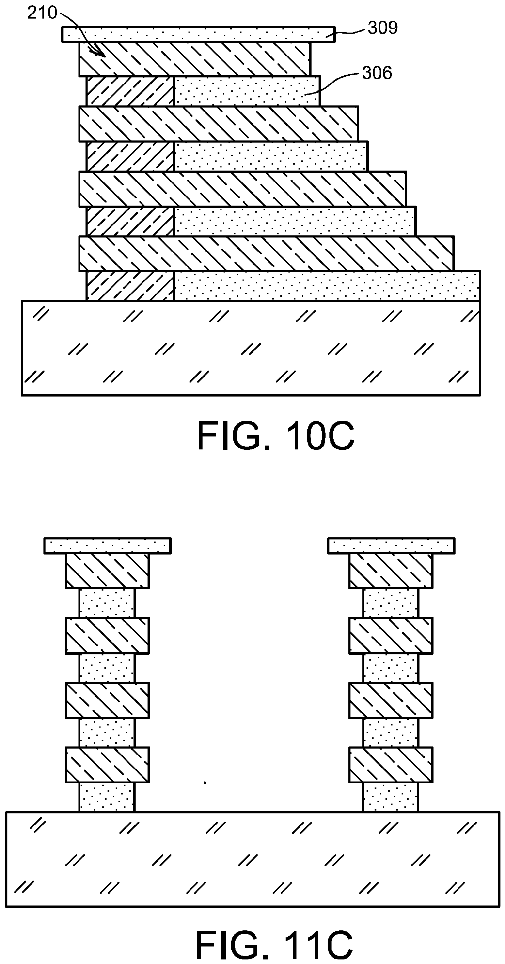

Suite à cette oxydation, les couches 304₁,..., 304₇ sont séparées les unes des autres par de l'oxyde de silicium 306 (figures 10B et 11B, le même empilement étant représenté, sur ces figures, respectivement, selon une vue de dessus, selon une vue en coupe transversale A'A et selon une vue en coupe transversale B'B indiquées sur la figure 9A).

En fixant les dimensions dans les directions parallèles au plan du substrat du bloc 210 de telle sorte qu'elles sont supérieures à la plus petite dimension dans les directions parallèles au plan du substrat de chacun des blocs 215 et 220a,..., 220f, on conserve un empilement semi-conducteur au niveau du premier bloc 210 de manière à assurer la continuité électrique entre les couches 304₁, ..., 304₇ au niveau de ce bloc.

Ensuite, on effectue un retrait partiel du matériau diélectrique 306, de manière à mettre à nu les flancs des couches 304₀,..., 304₇ au niveau des blocs 220a, ..., 220f. Le retrait peut être effectué par désoxydation partielle, par exemple à base d'acide fluorhydrique HF.

Ensuite, on forme un empilement de couches 352, 354, 356, comportant au moins une couche de diélectrique 352 de grille, par exemple à base d'un oxyde tunnel, tel que par exemple du SiO₂ d'épaisseur comprise par exemple entre 0,5 nanomètres et 10 nanomètres.

L'empilement de couches 352, 354, 356 comporte au moins une couche 354 de stockage d'électrons, formée d'un matériau tel qu'un diélectrique et selon une épaisseur, favorisant le stockage de charges. La couche 354 de stockage de charges, peut être par exemple à base de SiₓN_{y} ou un autre matériau diélectrique comportant des propriétés de piégeage similaires. La zone de stockage de charges peut également être formée d'îlots semi-conducteurs ou métalliques encapsulés dans une matrice diélectrique, tels que des îlots de Si, de Ge, de SiGe, de Pt, de W, de Co, de Ni, d'Au dans une matrice de SiₓO_{y}, de SiₓN_{y}. La couche 354 de stockage d'électrons, peut avoir une épaisseur comprise par exemple entre 1 nanomètre et 15 nanomètres.

L'empilement de couches 352, 354, 356 comporte également au moins une couche de diélectrique 356, par exemple à base d'un oxyde, tel que par exemple du SiO₂ d'épaisseur comprise par exemple entre 3 nanomètres et 20 nanomètres.

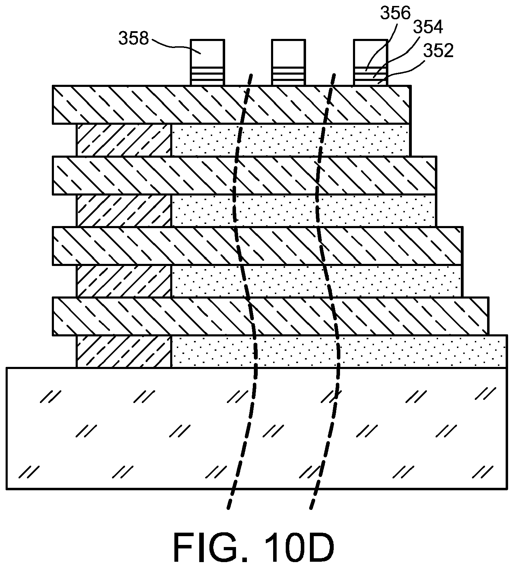

Ensuite, on effectue le dépôt d'un matériau de grille 358, par exemple à base de polysilicium, de TiN, de W, de polysilicium siliciuré, de TaN, de Pt, de PtSi ou d'une combinaison de ces matériaux, puis un polissage mécano-chimique (CMP) du matériau 358 de grille. Une gravure du matériau 358 de grille et de l'empilement de couches 352, 354, 356, est ensuite effectué, de manière à former des grilles (figures 10D et 11D, le même empilement 202 étant représenté, sur ces figures, selon une vue en coupe transversale A'A indiquée sur la figure 9A, et selon une vue en coupe transversale B'B).

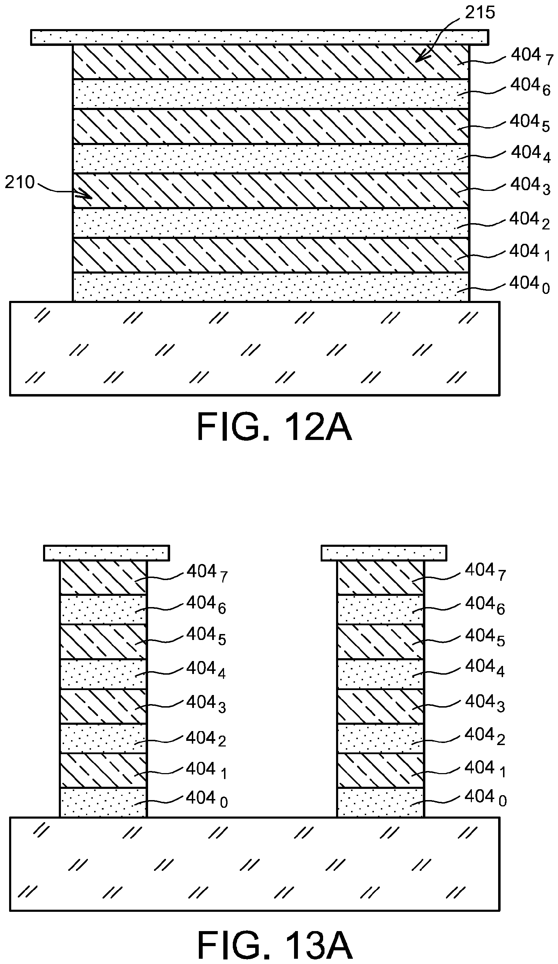

Selon une variante de l'exemple de procédé qui vient d'être décrit, le premier bloc 210, le deuxième bloc 215, et les blocs 220a, 220b, 220c, 220d, 220e, peuvent être formés à partir d'un empilement de couches 404₀, 404₁, 404₂, 404₃, 404₄, 404₅, 404₆, 404₇ et 404₈ formé d'une alternance de couches 404₁, 404₃, 404₅, 404₇, isolantes, et de couches 404₀, 404₂, 404₄ et 404₆ à base de matériau semi-conducteur (figures 12A et 13A).

Un tel empilement peut être formé par exemple de la manière décrite dans le document « direct wafer bonding & thinning down a generic technology to perform new structures », conférence ECS 2005.

Un tel empilement peut être réalisé par exemple à l'aide d'un procédé de type « smart cut » permettant de reporter une couche semi-conductrice, par exemple à base de silicium cristallin sur une couche isolante, par exemple à base d'oxyde de silicium. Un empilement formé d'une alternance de couches de silicium d'épaisseur comprise par exemple entre 15 nanomètres et 100 nanomètres, et de couches isolantes comprises entre 15 nanomètres et 100 nanomètres peut être ainsi formé.

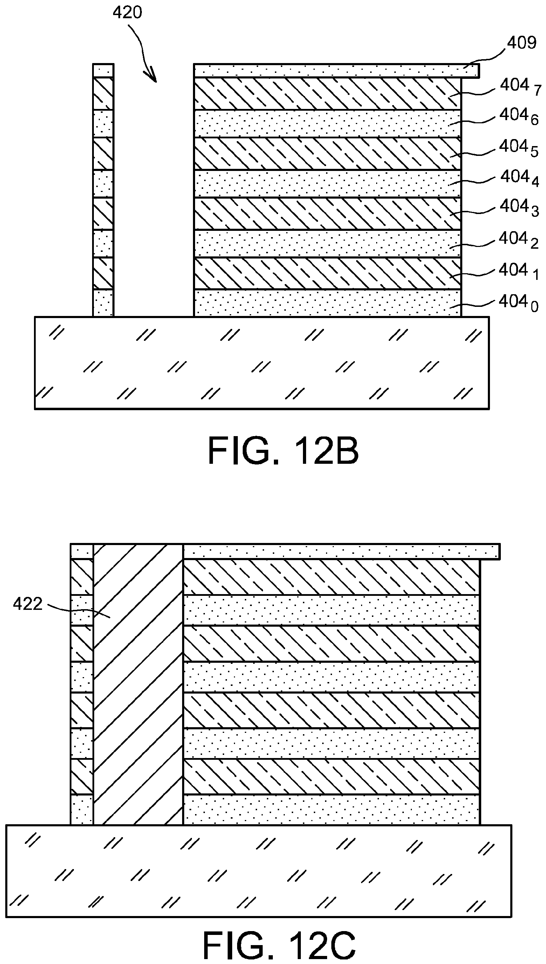

Avec un tel empilement, la réalisation d'une région de source commune peut être effectuée par exemple, par réalisation d'un trou 420 dans l'empilement, en protégeant ce dernier à l'aide d'un masquage 409 comportant une ouverture 411, au niveau du premier bloc 210 (figure 12B).

Le trou 420 peut être ensuite rempli à l'aide d'un matériau 422, par exemple à base de tungstène (figure 12C).

Un profil en escalier peut être réalisé dans l'empilement de couches 404₁, 404₂, 404₃, 404₄, 404₅, 404₆, 404₇ et 404₈. Un tel profil peut être réalisé par exemple de la manière indiquée précédemment dans l'exemple de procédé décrit en liaison avec les figures 6, 7 et 8.

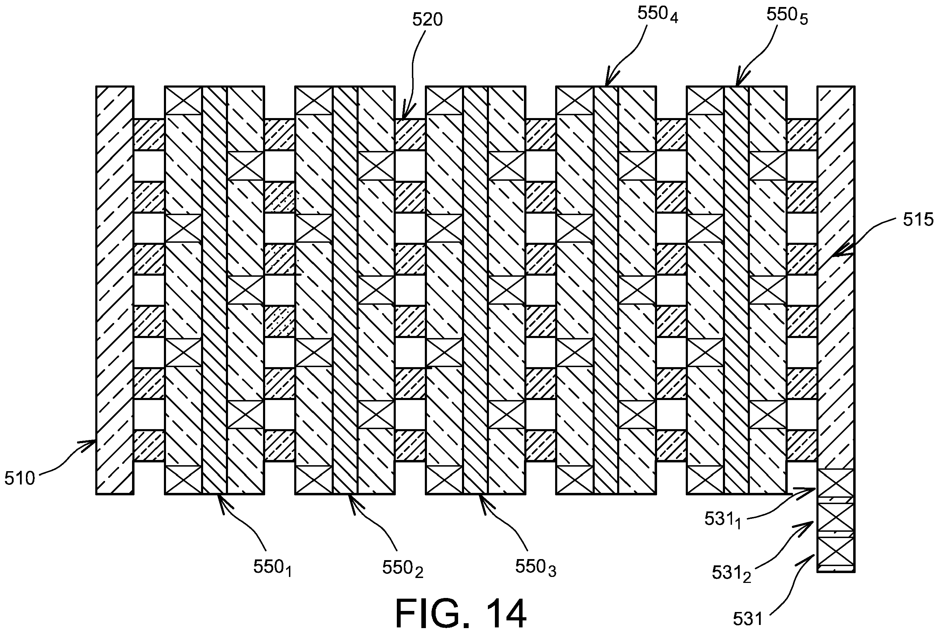

Un autre exemple de dispositif de mémoire flash avec un adressage particulier des grilles, est illustré sur la figure 14.

Dans ce dispositif, chaque cellule mémoire permet de coder deux bits, les transistors de la cellule étant à double-grille.

Un tel dispositif comprend une pluralité de cellules mémoires C réalisées dans un empilement de couches semi-conductrices. L'empilement gravé comporte au moins une premier bloc 510 dans lequel une région de source commune desdits transistors est formée. L'empilement gravé comporte également un deuxième bloc 515, ainsi qu'une pluralité d'autres blocs 520 distincts juxtaposés, reliant le premier bloc 510 et le deuxième bloc 515, lesdits autres blocs distincts comportant, un nombre N, par exemple tel que N=3 canaux de transistors, distincts parallèles entre eux (et parallèles au plan de la figure). Le dispositif comporte également une pluralité de grilles, et en particulier de doubles grilles 550₁, 550₂, 550₃, 550₄, 550₅. La matrice mémoire comporte 3 niveaux superposés de canaux, chaque niveau étant relié à une ligne de bit (non représentée) par l'intermédiaire de contacts 531₁, 531₂, 531₃.

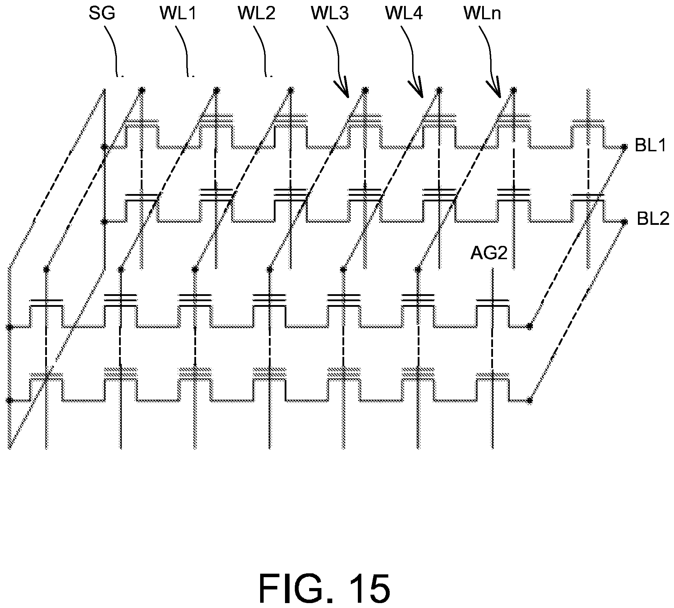

Un schéma électrique équivalent d'un exemple de mémoire suivant l'invention, est donné sur la figure 15.

Dans cet exemple, la mémoire comprend n lignes de mot WL₁,..., WLₙ connectées respectivement aux n grilles de contrôle de la matrice.

La matrice comporte également p lignes de bits BL₁, BL₂..., BLₚ connectées respectivement aux drains de transistors d'une même rangée horizontale de la matrice.

Le dispositif comprend également une première grille de sélection SG connectée à m*p transistors de la matrice, ainsi que m deuxièmes grilles de sélection, encore appelées grilles d'accès AG1,...,AGm, les grilles d'accès AG1,...,AGm étant respectivement partagées par les transistors d'une même rangée verticale de la matrice.

Une source commune aux transistors de la matrice est également prévue.

Un exemple de principe de fonctionnement et d'adressage d'une telle matrice mémoire, en termes de programmation, d'effacement et de lecture, va à présent être donné :

### A. Phase de programmation :

On souhaite programmer par exemple une cellule cible située au premier niveau de la matrice, à l'intersection entre une ligne de mot WL2 et une ligne de bit BL1.

Pour cela, on applique un potentiel V=V_{HIGH}, par exemple égal à 18 volts sur la ligne de mot WL2, de manière à créer un champ électrique suffisant dans la cellule, pour que les électrons de son canal traversent la première couche diélectrique, par exemple un oxyde tunnel, pour charger la zone de stockage d'électrons.

Dans cette phase de programmation, les autres lignes de mot WL de la matrice sont mises à un potentiel V_{PASS} par exemple égal à 10 volts. Ainsi, les transistors des cellules sont passants. Cependant V_{PASS} doit être suffisamment faible pour éviter une programmation parasite de ces cellules.

On met la source à la masse, en appliquant par exemple un potentiel V(SL) = 0V à une ligne de source.

On met une première grille du transistor, nommée grille de sélection à la masse. Le transistor d'accès situé du côté de la ligne de source est bloqué

On rend passant le transistor d'accès de la deuxième grille d'accès du transistor à programmer à un potentiel V_{CC} par exemple de l'ordre de 3 volts. On bloque les transistors d'accès des grilles d'accès des autres niveaux. Le potentiel des cellules de la ligne de bit BL1 est à la masse, tous les transistors connectés à cette ligne étant passants.

Les transistors des grilles d'accès des lignes de bits BL non programmées sont à V_{CC} pour qu'aucun courant ne passe à travers. Ainsi les lignes de bits BL des cellules non programmées sont bloquées, et le potentiel des canaux correspondants augmente par couplage capacitif. Il n'y a donc pas de champ électrique dans le canal suffisant pour qu'on programme la cellule mémoire. Les cellules connectées à la même ligne de bit du même niveau, ne sont pas programmées parce que leurs grilles sont polarisées à des tensions trop faibles. Les cellules connectées à la même ligne de mot WL et appartenant au même niveau, ne sont pas programmées parce que les lignes de bits de ce niveau sont à un potentiel V_{CC}.

Les cellules connectées à la même ligne de bit BL et à la même ligne de mot WL ne sont pas programmées dans la mesure où les transistors d'accès correspondants sont bloqués.

La cellule cible est programmée parce que sa ligne de bit BL est à la masse, son transistor d'accès est passant, sa ligne de mot WL est polarisée à la tension de programmation, et les cellules de sa même ligne de bit BL sont toutes passantes.

### B. Phase d'effacement :

L'effacement peut être fait par secteur comme dans une matrice mémoire conventionnelle, en connectant électriquement la source commune avec un contact body.

### C. Phase de Lecture :

On souhaite à présent lire la cellule cible. La lecture peut être faite comme dans une mémoire Flash NAND conventionnelle. La sélection d'un plan mémoire par rapport à l'autre se fait en bloquant les grilles d'accès des plans mémoires non sélectionnés.

## Revendications

1. Dispositif microélectronique de mémoire flash comprenant :
- un support (100, 200),
- une pluralité de cellules mémoires comportant des transistors réalisés dans un empilement (202, 302, 402) gravé de couches reposant sur ledit support dont une pluralité de couches semi-conductrices, l'empilement gravé comportant au moins un premier bloc (110, 210, 310, 410) de source commune desdits transistors, et au moins un deuxième bloc (215,315,415) dans lequel des régions de drain et des zones de prises de contact sur ces régions de drain sont réalisées,
- une pluralité d'autres blocs (120, 220, 220a, 220b, 220c, 220d, 220e, 220f) distincts juxtaposés, reliant le premier bloc (110, 210, 310, 410) et le deuxième bloc (215, 315, 415), lesdits autres blocs (120, 220, 220a, 220b, 220c, 220d, 220e, 220f) distincts comportant, dans une direction orthogonale au plan principal du support (100, 200), plusieurs canaux de transistors, distincts et parallèles entre eux et au plan principal du support (100, 200), lesdits canaux étant répartis selon un arrangement matriciel de rangées horizontales et de rangées verticales de canaux,
- une pluralité de grilles formées d'au moins un matériau de grille dont :
- une première grille de sélection (140, 240) enrobant lesdits canaux,
- une pluralité de grilles de contrôle (150, ..., 150n, 250, ..., 250n) enrobant lesdits canaux,
- une pluralité de deuxièmes grilles de sélection (160₁, ..., 160m, 260₁, ..., 260m) enrobant chacune les canaux d'une même rangée verticale de l'arrangement matriciel,
au moins une ou plusieurs desdites grilles reposant sur une superposition de couches comportant au moins une première couche de matériau diélectrique (252, 352) au moins une zone de stockage de charges (254, 354), et au moins une deuxième couche de matériau diélectrique (256, 356), le deuxième bloc (215, 315, 415) comportant un profil en escalier avec une pluralité de marches (E1, E2, E3, E4, E5) formant respectivement des zones de contact de lignes de bit (130, 230)
une pluralité de lignes de bit (130₁, ..., 130n, 230) parallèles au plan principal du support disposées sur ledit deuxième bloc, chaque ligne de bit (130₁, ..., 130n, 230) étant connectée aux drains de transistors d'une même rangée horizontale de l'arrangement matriciel.

2. Dispositif microélectronique selon la revendication 1, dans lequel l'empilement (302) est formé d'une alternance de couches (304₀, 304₂, 304₆), à base d'un matériau semi-conducteur dopé selon une dose donnée, et de couches (304₁, 304₃, 304₅, 304₇) à base dudit matériau semi-conducteur non dopé, ou dopé selon une autre dose, différente de ladite dose donnée.

3. Dispositif microélectronique selon la revendication 1, dans lequel ledit empilement (402) est formé d'une alternance de couches (404₀, 404₂, 404₄, 404₆) à base d'un matériau semi-conducteur donné, et de couches (404₁, 404₃, 404₅, 404₇) à base d'un matériau isolant, lesdits canaux étant formés dans ledit matériau semi-conducteur donné.

4. Dispositif microélectronique selon la revendication 1, ledit empilement (202) étant formé d'une alternance de couches à base d'un premier matériau semi-conducteur (206), et de couches à base d'un deuxième matériau semi-conducteur (207), différent du premier matériau semi-conducteur, lesdits canaux de transistors étant formés dans ledit premier matériau semi-conducteur (206).

5. Dispositif microélectronique selon l'une des revendications 1 à 4, ladite zone de stockage (254, 354) de charges étant à base d'un matériau diélectrique tel que du SiₓN_{y}, ou étant une couche de matériau diélectrique comportant des ilots semi-conducteurs ou conducteurs.

6. Procédé de réalisation d'un dispositif microélectronique de mémoire flash comprenant les étapes de :
a) formation sur un support (100, 200) d'un empilement (202, 302, 402) gravé de couches comportant une pluralité de couches semi-conductrices,
b) gravure de l'empilement (202, 302, 402) de manière à former au moins une premier bloc (110, 210, 310, 410) dans lequel une région de source commune est destinée à être réalisée, et au moins un deuxième bloc (215, 315, 415) dans lequel des régions de drain et des zones de prises de contact sur ces régions de drain sont destinées à être réalisées, ainsi qu'une pluralité de blocs distincts juxtaposés (220a, 220b, 220c, 220d, 220e, 220f) reliant le premier (110, 210, 310, 410) et le deuxième bloc (215, 315, 415), lesdits blocs distincts (220a, 220b, 220c, 220d, 220e, 220f) comprenant respectivement plusieurs barreaux destinés à former des canaux de transistors, les barreaux étant alignés dans une direction réalisant un angle non-nul avec un plan principal du support (100, 200),
c) réalisation de zones formées d'une superposition de couches (252, 254, 256, 352, 354, 356) comportant au moins une première couche de matériau diélectrique de grille (252, 352), au moins une couche de stockage de charges (254, 354), et au moins une deuxième couche de matériau diélectrique de grille (256, 356),
d) réalisation de grilles, au moins plusieurs desdites grilles reposant respectivement sur lesdites zones dont :
- une première grille de sélection (140, 240) enrobant lesdits canaux,
- une pluralité de grilles de contrôle (150₁, ..., 150n, 250₁, ..., 250n) enrobant lesdits canaux,
- une pluralité de deuxièmes grilles de sélection (160₁, ..., 160m, 260₁, ..., 260m) enrobant chacune les canaux d'une même rangée de l'arrangement matriciel,
au moins une ou plusieurs desdites grilles reposant sur une superposition de couches comportant au moins une première couche de matériau diélectrique, (252, 352) au moins une zone de stockage de charges (254, 354), et au moins une deuxième couche de matériau diélectrique (256, 356), le procédé comprenant en outre : la réalisation d'au moins un profil en escalier au niveau du deuxième bloc (115, 215, 315, 415), ledit profil en escalier comportant une pluralité de marches (E1, E2, E3, E4, E5), au moins une ou plusieurs desdites marches étant prévues pour former des zones de prise de contact avec des lignes de bits (230₁, ..., 230p),
- une pluralité de lignes de bit (130, ..., 130n, 230) parallèles au plan principal du support disposées sur ledit deuxième bloc (215), chaque ligne de bit étant connectée aux drains de transistors d'une même rangée horizontale de l'arrangement matriciel.

7. Procédé microélectronique selon la revendication 6, dans lequel l'empilement (202) est formé d'une alternance de couches à base d'un premier matériau semi-conducteur (206), et de couches à base d'un deuxième matériau semi-conducteur (207), différent du premier matériau semi-conducteur (206), les canaux étant formés ou destinés à être formés dans le premier matériau semi-conducteur (206), le procédé comprenant entre l'étape b) et l'étape c) :
- la gravure sélective du deuxième matériau semi-conducteur (207) vis-à-vis du premier matériau semi-conducteur (206), de manière à réduire la surface des couches à base du deuxième matériau semi-conducteur (207),
- la réalisation d'espaceurs isolants autour des couches à base du deuxième matériau semi-conducteur (206).

8. Procédé selon la revendication 6, l'empilement (302) étant formé d'une alternance de premières couches (304₀, 304₂, 304₄, 304₆) à base d'un matériau semi-conducteur dopé selon une dose donnée, et de deuxièmes couches (304₁, 304₃, 304₅, 304₇) à base dudit matériau semi-conducteur non dopé ou dopé selon une autre dose, inférieure à ladite dose donnée, le procédé comprenant après l'étape c) : l'oxydation préférentielle desdites premières couches (304₀, 304₂, 304₄, 304₆) vis-à-vis desdites deuxièmes couches (304₁, 304₃, 304₅, 304₇), de manière à former un matériau isolant séparant dans l'empilement lesdites premières couches (304₀, 304₂, 304₄, 304₆) entre elles, à l'exception d'au moins une région du premier bloc (310) dans laquelle une partie des premières couches semi-conductrices (304₀, 304₂, 304₄, 304₆) et des deuxièmes couches semi-conductrices (304₁, 304₃, 304₅, 304₇) n'est pas oxydée .

9. Procédé microélectronique selon la revendication 6 ou 7, comprenant en outre, après l'étape b) : le dopage en surface des couches de l'empilement (202) à base du premier matériau semi-conducteur (206).

10. Procédé microélectronique selon l'une des revendications 6 à 9, le procédé comprenant en outre, après l'étape b), la réalisation d'une source commune (210) par :
- réalisation d'un masquage sur le second bloc (215) et lesdits autres blocs (220a, 220b, 220c, 220d, 220e, 220f), ledit masquage dévoilant ledit premier bloc (210),
- dopage des couches semi-conductrices dudit premier bloc (210).

11. Procédé selon la revendication 6, l'empilement (402) étant formé d'une alternance de couches (404₀, 404₂, 404₄, 404₆) à base d'un matériau semi-conducteur, et de couches (404₁, 404₃, 404₅, 404₇) à base d'un matériau isolant.

12. Procédé microélectronique selon la revendication 11, comprenant la réalisation d'une source commune dans ledit premier bloc (410), la réalisation de la source commune comprenant des étapes de :
- formation d'au moins un trou (420) dans ledit premier bloc (410) de l'empilement (402) à travers un masquage,
- remplissage dudit trou (420) à l'aide d'au moins un matériau conducteur ou semi-conducteur.

13. Procédé microélectronique selon l'une des revendications 6 à 12, comprenant la réalisation d'une source commune dans ledit premier bloc (110, 210, 310, 410), la réalisation de la source commune comprenant des étapes de :
- réalisation d'un masquage sur le second bloc (215, 315, 415) et lesdits autres blocs, ledit masquage dévoilant ledit premier bloc (110, 210, 310, 410),
- dopage des couches semi-conductrices dudit premier bloc (110, 210, 310, 410).

## Patentansprüche

1. Mikroelektronische Flash-Speichervorrichtung, enthaltend:
- einen Träger (100, 200),
- eine Mehrzahl von Speicherzellen, die Transistoren enthalten, die in einer geätzten Stapelung (202, 302, 402) von Schichten ausgeführt sind, die auf dem Träger aufliegen, darunter eine Mehrzahl von Halbleiterschichten, wobei die geätzte Stapelung zumindest einen ersten Block (110, 210, 310, 410) mit gemeinsamer Source der Transistoren und zumindest einen zweiten Block (215, 315, 415) aufweist, wobei Drainbereiche und Kontaktierungsbereiche auf diesen Drainbereichen ausgebildet sind,
- eine Mehrzahl von weiteren separaten, nebeneinandergeordneten Blöcken (120, 220, 220a, 220b, 220c, 220d, 220e, 220f), die den ersten Block (110, 210, 310, 410) und den zweiten Block (215, 315,415) verbinden, wobei die weiteren, separaten Blöcke (120, 220, 220a, 220b, 220c, 220d, 220e, 220f) in einer zur Hauptebene des Trägers (100, 200) orthogonalen Richtung mehrere separate Transistorkanäle enthalten, die parallel zueinander und zur Hauptebene des Trägers (100, 200) verlaufen,
wobei die Kanäle nach einer Matrixanordnung von horizontalen Reihen und vertikalen Reihen von Kanälen verteilt sind,
- eine Mehrzahl von Gates, die aus zumindest einem Gate-Material hergestellt sind, darunter:
- ein erstes Selektions-Gate (140, 240), das die Kanäle umgibt,
- eine Mehrzahl von Steuer-Gates (150, ..., 150n, 250, ..., 250n), die die Kanäle umgeben,
- eine Mehrzahl von zweiten Selektions-Gates (160, ..., 160m, 260, ... 260m), die jeweils die Kanäle einer gleichen vertikalen Reihe der Matrixanordnung umgeben,
wobei zumindest eines oder mehrere der Gates auf einer Übereinanderordnung von Schichten aufliegen, die zumindest eine erste Schicht aus dielektrischem Material (252, 352), zumindest einen Ladungsspeicherbereich (254, 354) und zumindest eine zweite Schicht aus dielektrischem Material (256, 356) enthält,
wobei der zweite Block (215, 315, 415) ein Treppenprofil mit einer Mehrzahl von Stufen (E1, E2, E3, E4, E5) enthält, die jeweils Bitleitungskontaktbereiche (130, 230) bilden,
eine Mehrzahl von Bitleitungen (130₁, ..., 130n, 230), die parallel zur Hauptebene des Trägers verlaufen und an dem zweiten Block angeordnet sind, wobei jede Bitleitung (130₁, ..., 130n, 230) mit den Transistor-Drains einer gleichen horizontalen Reihe der Matrixanordnung verbunden ist.

2. Mikroelektronische Vorrichtung nach Anspruch 1, wobei die Stapelung (302) aus einer Wechselfolge von Schichten (304₀, 304₂, 304₄, 304₆) auf Basis eines Halbleitermaterials, das mit einem gegebenen Dotierungsgrad dotiert ist, und von Schichten (304₁, 304₃, 304₅, 304₇) auf Basis des Halbleitermaterials gebildet ist, das nicht dotiert ist oder mit einem anderen Dotierungsgrad dotiert ist, der sich von dem gegebenen Dotierungsgrad unterscheidet.

3. Mikroelektronische Vorrichtung nach Anspruch 1, wobei die Stapelung (402) aus einer Wechselfolge von Schichten (404₀, 404₂, 404₄, 404₆) auf Basis eines gegebenen Halbleitermaterials und von Schichten (404₁, 404₃, 404₅, 404₇) auf Basis eines Isoliermaterials gebildet ist, wobei die Kanäle aus dem gegebenen Halbleitermaterial gebildet sind.

4. Mikroelektronische Vorrichtung nach Anspruch 1, wobei die Stapelung (202) aus einer Wechselfolge von Schichten auf Basis eines ersten Halbleitermaterials (206) und von Schichten auf Basis eines zweiten Halbleitermaterials (207) gebildet ist, das sich von dem ersten Halbleitermaterial unterscheidet, wobei die Transistor-Kanäle aus dem ersten Halbleitermaterial (206) gebildet sind.

5. Mikroelektronische Vorrichtung nach einem der Ansprüche 1 bis 4, wobei der Ladungsspeicherbereich (254, 354) auf Basis eines dielektrischen Materials, wie etwa SiₓN_{y}, besteht oder eine Schicht aus dielektrischem Material ist, die Halbleiter- bzw. Leiterinseln enthält.

6. Verfahren zum Herstellen einer mikroelektronischen Flash-Speichervorrichtung, umfassend die nachfolgenden Schritte:
a) Ausbilden einer geätzten Stapelung (202, 302, 402) von Schichten auf einem Träger (100, 200), die eine Mehrzahl von Halbleiterschichten enthält,
b) Ätzen der Stapelung (202, 302, 402) so, dass zumindest ein erster Block (110, 210, 310, 410), bei dem ein gemeinsamer Sourcebereich ausgebildet werden soll, und zumindest ein zweiter Block (215, 315, 415) gebildet werden, bei dem Drainbereiche und Kontaktierungsbereiche auf diesen Drainbereichen ausgebildet werden sollen, sowie eine Mehrzahl von separaten, nebeneinandergeordneten Blöcken (220a, 220b, 220c, 220d, 220e, 220f), die den ersten Block (110, 210, 310, 410) und den zweiten Block (215, 315, 415) verbinden, wobei die separaten Blöcke (220a, 220b, 220c, 220d, 220e, 220f) jeweils mehrere Stäbe enthalten, die dazu bestimmt sind, Transistorkanäle zu bilden, wobei die Stäbe in einer Richtung fluchten, die einen Winkel ungleich null mit einer Hauptebene des Trägers (100, 200) einschließt,
c) Ausbilden von Bereichen, die aus einer Übereinanderordnung von Schichten (252, 254, 256, 352, 354, 356) gebildet sind, die zumindest eine erste Schicht aus dielektrischem Gate-Material (252, 352), zumindest eine Ladungsspeicherschicht (254, 354) und zumindest eine zweite Schicht aus dielektrischem Gate-Material (256, 356) enthält,
d) Ausbilden von Gates, wobei zumindest mehrere der Gates auf den jeweiligen Bereichen aufliegen, darunter:
- ein erstes Selektions-Gate (140, 240), das die Kanäle umgibt,
- eine Mehrzahl von Steuer-Gates (150₁, ..., 150n, 250, ..., 250n), die die Kanäle umgeben,
- eine Mehrzahl von zweiten Selektions-Gates (160₁, ..., 160m, 260₁, ... 260m), die jeweils die Kanäle einer gleichen Reihe der Matrixanordnung umgeben, wobei zumindest eines oder mehrere der Gates auf einer Übereinanderordnung von Schichten aufliegen, die zumindest eine erste Schicht aus dielektrischem Material (252, 352), zumindest einen Ladungsspeicherbereich (254, 354) und zumindest eine zweite Schicht aus dielektrischem Material (256, 356) enthält,
wobei das Verfahren ferner umfasst:
Ausbilden zumindest eines Treppenprofils im Bereich des zweiten Blocks (115, 215, 315, 415), wobei das Treppenprofil eine Mehrzahl von Stufen (E1, E2, E3, E4, E5) enthält, wobei zumindest eine oder mehrere der Stufen dazu vorgesehen sind, Kontaktierungsbereiche mit Bitleitungen (230₁, ..., 230p) zu bilden,
- eine Mehrzahl von Bitleitungen (130, ..., 130n, 230), die parallel zur Hauptebene des Trägers verlaufen und an dem zweiten Block (215) angeordnet sind, wobei jede Bitleitung mit den Transistor-Drains einer gleichen horizontalen Reihe der Matrixanordnung verbunden ist.

7. Mikroelektronisches Verfahren nach Anspruch 6, wobei die Stapelung (202) aus einer Wechselfolge von Schichten auf Basis eines ersten Halbleitermaterials (206) und von Schichten auf Basis eines zweiten Halbleitermaterials (207) gebildet ist, das sich von dem ersten Halbleitermaterial (206) unterscheidet, wobei die Kanäle aus dem ersten Halbleitermaterial (206) gebildet sind bzw. gebildet werden sollen, wobei das Verfahren zwischen Schritt b) und Schritt c) umfasst:
- selektives Ätzen des zweiten Halbleitermaterials (207) gegenüber dem ersten Halbleitermaterial (206), so dass die Fläche der Schichten auf Basis des zweiten Halbleitermaterials (207) vermindert wird,
- Ausbilden von isolierenden Abstandshaltern um die Schichten auf Basis des zweiten Halbleitermaterials (206) herum.

8. Verfahren nach Anspruch 6, wobei die Stapelung (302) aus einer Wechselfolge von ersten Schichten (304₀, 304₂, 304₄, 304₆) auf Basis eines Halbleitermaterials, das mit einem gegebenen Dotierungsgrad dotiert ist, und von zweiten Schichten (304₁, 304₃, 304₅, 304₇) auf Basis des Halbleitermaterials gebildet ist, das nicht dotiert bzw. mit einem anderen Dotierungsgrad dotiert ist, der geringer als der gegebene Dotierungsgrad ist, wobei das Verfahren nach Schritt c) umfasst:
präferenzielles Oxidieren der ersten Schichten (304₀, 304₂, 304₄, 304₆) gegenüber den zweiten Schichten (304₁, 304₃, 304₅, 304₇), so dass ein Isoliermaterial gebildet wird, das in der Stapelung die ersten Schichten (304₀, 304₂, 304₄, 304₆) voneinander trennt, mit Ausnahme von zumindest einem Bereich des ersten Blocks (310), in welchem ein Teil der ersten Halbleiterschichten (304₀, 304₂, 304₄, 304₆) und der zweiten Halbleiterschichten (304₁, 304₃, 304₅, 304₇) nicht oxidiert wird.

9. Mikroelektronisches Verfahren nach Anspruch 6 oder 7, ferner umfassend nach Schritt b):
Oberflächen-Dotieren der Schichten der Stapelung (202) auf Basis des ersten Halbleitermaterials (206).

10. Mikroelektronisches Verfahren nach einem der Ansprüche 6 bis 9, wobei das Verfahren ferner nach Schritt b) umfasst:
Ausbilden einer gemeinsamen Source (210) durch:
- Ausbilden einer Maskierung an dem zweiten Block (215) und an den weiteren Blöcken (220a, 220b, 220c, 220d, 220e, 220f), wobei die Maskierung den ersten Block (210) freilegt,
- Dotieren der Halbleiterschichten des ersten Blocks (210).

11. Verfahren nach Anspruch 6, wobei die Stapelung (402) aus einer Wechselfolge von Schichten (404₀, 404₂, 404₄, 404₆) auf Basis eines Halbleitermaterials und von Schichten (404₁, 404₃, 404₅, 404₇) auf Basis eines Isoliermaterials gebildet wird.

12. Mikroelektronisches Verfahren nach Anspruch 11, umfassend das Ausbilden einer gemeinsamen Source in dem ersten Block (410), wobei das Ausbilden der gemeinsamen Source die nachfolgenden Schritte umfasst:
- Ausbilden zumindest einer Lochung (420) in dem ersten Block (410) der Stapelung (402) durch eine Maskierung hindurch,
- Auffüllen der Lochung (420) mit Hilfe des zumindest einen Leitermaterials bzw. Halbleitermaterials.

13. Mikroelektronisches Verfahren nach einem der Ansprüche 6 bis 12, umfassend das Ausbilden einer gemeinsamen Source in dem ersten Block (110, 210, 310, 410), wobei das Ausbilden der gemeinsamen Source die nachfolgenden Schritte umfasst:
- Ausbilden einer Maskierung an dem zweiten Block (215, 315, 415) und den weiteren Blöcken, wobei die Maskierung den ersten Block (110, 210, 310, 410) freilegt,
- Dotieren der Halbleiterschichten des ersten Blocks (110, 210, 310, 410).

## Claims

1. A microelectronic device of flash memory comprising:
- a substrate (100, 200),
- a plurality of memory cells comprising transistors made in an etched stack (202, 302, 402) of layers based on said substrate whereof a plurality of semi-conductor layers, the etched stack comprising at least one first block (110, 310, 410) of common source of said transistors, and at least one second block (215, 315, 415) in which drain regions and contact zones are formed,
- a plurality of other blocks (120, 220, 220a, 220b, 220c, 220d, 220e, 220f) distinct and juxtaposed, connecting the first block (110, 310, 410) and the second block (215, 315, 415), said other distinct blocks comprising, in a direction orthogonal to the principal plane of the substrate (100, 200), several transistor channels, distinct and parallel to each other and to the principal plane of the substrate (100, 200), being distributed according to a matricial arrangement of horizontal rows and vertical rows of channels,
- a plurality of gates formed by at least one gate material, including:
- a first selection gate (140, 240) coating said channels,
- a plurality of control gates (150₁, ..., 150ₙ, 250₁, ..., 250ₙ) coating said channels,
- a plurality of second selection gates (160₁, ..., 160ₘ, 260₁, ..., 260ₘ) each coating the channels of the same row of the matricial arrangement,
at least one or more of said gates based on a superposition of layers comprising at least one first layer of dielectrical material (252, 352) at least one charge storage zone (354, 354), and at least one second layer of dielectrical material (256, 356),
the second block (215) having at least one stepped profile, said stepped profile comprising a plurality of steps (E1, E2, E3, E4, E5), at least one or more of said steps being provided to form bit lines contacting zones,
- a plurality of bit lines (130₁, ..., 130n, 230) parallel to the principal plane of the substrate is arranged on the second block, each bit line (130₁, ..., 130n, 230) being connected to the drains of a same horizontal row of the matricial arrangement.

2. The microelectronic device as claimed in Claim 1, in which the stack (302) is formed by alternating layers (304₀, ..., 304₂, 304₄, 304₆) based on semi-conductor material doped according to a given dose, and layers (304₁, ..., 304₃, 304₅, 304₇) based on said non-doped semi-conductor material, or doped according to another dose, different to said given dose.

3. The microelectronic device as claimed in Claim 1, in which said stack (402) is formed by alternating layers (404₀, ..., 404₂, 404₄, 404₆) based on a given semi-conductor material, and layers (404₁, ..., 404₃, 404₅, 404₇) based on insulating material, said channels being formed in said given semi-conductor material.

4. The microelectronic device as claimed in Claim 1, said stack (202) being formed by alternating layers based on a first semi-conductor material (206), and layers based on a second semi-conductor material (207), different to the first semi-conductor material, said transistor channels being formed in said first semi-conductor material (206).

5. The microelectronic device as claimed in any one of claims 1 to 4, said charge storage zone (254, 354) being based on dielectrical material such as SiₓN_{y}, or being a layer of dielectrical material comprising semi-conductor or conductor islets.

6. A production method of a microelectronic flash memory device comprising the steps of:
a) formation on a substrate (100, 200) of an etched stack (202, 302, 402) of layers comprising a plurality of semi-conductor layers,
b) etching of the stack (202, 302, 402) to form at least one first block (210, 310, 410) in which a common source region is intended to be made, and at least one second block, as well as a plurality of distinct juxtaposed blocks (220a, 220b, 220c, 220d, 220e, 220f) connecting the first block (110, 210, 310, 410) and the second block (215, 315, 415), said distinct blocks (220a, 220b, 220c, 220d, 220e, 220f) respectively comprising several bars designed to form transistor channels, the bars being aligned in a direction forming a non-zero angle with a principal plane of the substrate (100, 200),
c) making of zones formed by superposition of layers (252, 254, 256, 352, 354, 356) comprising at least one first layer of dielectrical gate material (252, 352), at least one charge storage layer (254, 354), and at least one second layer of dielectrical gate material (256, 356),
d) making of gates, at least several of said gates based respectively on said zones whereof:
- a first selection gate (140, 240) coating said channels,
- a plurality of control gates (150₁, ..., 150ₙ, 250₁, ..., 250ₙ) coating said channels,
- a plurality of second selection gates (160₁, ..., 160ₘ, 260₁, ..., 260ₘ) each coating the channels of the same row of the matricial arrangement,
at least one or more of said gates based on superposition of layers comprising at least one first layer of dielectrical material (252, 352) at least one charge storage zone (254, 354), and at least one second layer of dielectrical material (256, 356),
the method further comprising forming at least one stepped profile on said second block (215), at least one or more of said steps being provided to form bit lines contacting zones,
- a plurality of bit lines (130₁, ..., 130n, 230) parallel to the principal plane of the substrate is arranged on the second block, each bit line (130₁, ..., 130n, 230) being connected to the drains of a same horizontal row of the matricial arrangement.

7. The microelectronic method as claimed in Claim 6, in which the stack (202) is formed by alternating layers based on a first semi-conductor material (206), and of layers based on a second semi-conductor material (207), different to the first semi-conductor material (206), the channels being formed or designed to be formed in the first semi-conductor material (206), the method comprising between the step b) and the step c):
- selective etching of the second semi-conductor material (207) vis-a-vis the first semi-conductor material (206) so as to reduce the surface of layers based on the second semi-conductor material (207),
- forming of insulating spacers about layers based on the second semi-conductor material (206).

8. The method as claimed in Claim 6, the stack (302) being formed by alternating first layers (304₀, ..., 304₂, 304₄, 304₆) based on a semi-conductor material doped according to a given dose, and second layers (304₁, ..., 304₃, 304s, 304₇) based on said non-doped or doped semi-conductor material according to another dose, less than said given dose, the method comprising after step c): preferable oxidation of said first layers (304₀, ..., 304₂, 304₄, 304₆) vis-a-vis said second layers (304₁, ..., 304₃, 304₅, 304₇) to form insulating material separating in the stack said first layers from one another, with the exception of at least one region of the first block (310) in which part of the first semi-conductor layers (304₀, ..., 304₂, 304₄, 304₆) and second semi-conductor layers (304₁, ..., 304₃, 3045, 3047) is not oxidised.

9. The microelectronic method as claimed in Claim 6 or 7, also comprising after step b): the surface doping of layers of the stack based on the first semi-conductor material (206).

10. The microelectronic method as claimed in any one of Claims 6 to 9, the method also comprising, after step b), forming a common source (210) by:
- creating masking on the second block (215) and said other blocks (220a, 220b, 220c, 220d, 220e, 220f), said masking revealing said first block (210),
- doping of semi-conductor layers of said first block (210).

11. The method as claimed in Claim 6 the stack (402) being formed by alternating layers (404₀, ..., 404₂, 404₄, 404₆) based on a semi-conductor material, and layers (404₁, ..., 404₃, 404₅, 404₇) based on an insulating material.

12. The microelectronic method as claimed in Claim 11, comprising producing a common source in said first block (410), producing the common source comprising steps of:
- formation of at least one hole (420) in said first block (410) of the stack (402) through masking,
- filling of said hole (420) by means of at least one conductor or semi-conductor material.

13. The microelectronic method as claimed in any one of Claims 6 to 12, comprising producing a common source in said first block (110, 210, 310, 410), producing the common source comprising steps of:
- creating masking on the second block (215, 315, 415) and said other blocks, said masking revealing said first block (110, 210, 310, 410),
- doping the semi-conductor layers of said first block.
